# EUROPEAN PATENT APPLICATION

(11) **EP 3 474 379 A1**
(43) Date of publication of application: **24.04.2019**
(21) Application number: 18200149.5
(22) Date of filing: 12.10.2018
(51) Int. Cl.: H01Q 9/04, H01Q 21/06, H01Q 21/00, H01Q 1/52, H01Q 1/12

(54) **STACKED PATCH ANTENNA ELEMENTS AND ANTENNA ASSEMBLIES**

(30) Priority: 19.10.2017 US 201762574644 P; 29.08.2018 US 201862724437 P
(71) Applicant: Laird Technologies, Inc., Chesterfield, MO 63017 (US)
(72) Inventor: Russell, Erick J., Chesterfield, Missouri 63017 (US); Ramberg, Henrik Karl, Chesterfield, Missouri 63017 (US); Johnson, Shawn W., Chesterfield, Missouri 63017 (US)
(74) Representative: AWA Sweden AB

(57) **Abstract**

Disclosed herein are exemplary embodiments of stacked patch antenna elements. Also disclosed herein are exemplary embodiments of antenna assemblies (*e.g*., MIMO antenna assemblies, single antenna element assemblies, *etc.*) that include one or more stacked patch antenna elements. Exemplary methods of manufacturing or assembling stacked patch antenna elements and antenna assemblies are also disclosed herein.

## Description

### FIELD

The present disclosure generally relates to stacked patch antenna elements and antenna assemblies.

### BACKGROUND

This section provides background information related to the present disclosure which is not necessarily prior art.

Stacked patch antenna elements are commonly used for MIMO (multiple input, multiple output) antenna assemblies. For example, a conventional MIMO antenna assembly may include an array of stacked patched antenna elements.

### DRAWINGS

The drawings described herein are for illustrative purposes only of selected embodiments and not all possible implementations, and are not intended to limit the scope of the present disclosure.
FIGS. 1 and 2 are exploded upper and lower perspective views of a stacked patch antenna element including upper and lower patches, a dielectric carrier, and an isolation box according to an exemplary embodiment.
FIG. 3 is a perspective view of the stacked patch antenna element shown in FIGS. 1 and 2 after being assembled such that the upper and lower patches are mechanically coupled to or along opposite upper and lower sides of the dielectric carrier and such that the upper and lower patches are within the isolation box.
FIG. 4 is a perspective view of "tape and reel" packaging for automatic placement that includes four stacked patch antenna elements as shown in FIGS. 1 and 2 according to an exemplary embodiment.
FIG. 5 is a perspective view of a subarray that includes two stacked patch antenna elements as shown in FIGS. 1, 2, and 3 according to an exemplary embodiment.
FIG. 6 is a bottom view of the subarray shown in FIG. 5 and showing example feeding network for the subarray.
FIG. 7 is a side view of the subarray shown in FIG. 5.
FIG. 8 illustrates an example antenna array or MIMO antenna assembly including two rows of four subarrays as shown in FIG. 5 according to an exemplary embodiment.
FIG. 9 illustrates an exemplary feed network for the subarrays of the example antenna array shown in FIG. 8.
FIG. 10 is a perspective view of the MIMO antenna assembly shown in FIG. 8 that includes two rows of four subarrays, isolation rails, and a multilayer (*e*.*g*., four layer, *etc*.) PCB including a feeding network.
FIG. 11 is another perspective view of the MIMO antenna assembly shown in FIG. 10, and also illustrating an example radome that may be positioned over the stacked patch antenna elements.
FIG. 12 is a perspective view of an exemplary isolation rail that may be used in the MIMO antenna assembly shown in FIG. 10.
FIG. 13 includes an exemplary line graph of horizontal radiation patterns showing gain in decibels (dB) versus Phi in degrees for a row of four stacked patch antenna elements shown in FIG. 8 having the same polarization.
FIG. 14 includes an exemplary line graph of return loss in decibels versus frequency from 3.4 Gigahertz (GHz) to 3.6 GHz for all sixteen stacked patch antenna elements shown in FIG. 8.
FIG. 15 includes an exemplary line graph of isolation in decibels versus frequency from 3.4 GHz to 3.6 GHz between all eight subarrays of the stacked patch antenna elements shown in FIG. 8.
FIG. 16 is a perspective views of a stacked patch antenna element including an upper patch, a lower patch, a dielectric carrier supporting the patches, and an isolation fence or box according to an exemplary embodiment.
FIG. 17 is a bottom view of the stacked patch antenna element shown in FIG. 16, and illustrating the symmetrical feed provided by the symmetrical capacitive probes for capacitively feeding the patches. Also shown in FIG. 17 are openings (*e*.*g*., cutouts, stamped portions, *etc*.) in the lower patch between the capacitive probes and a center of the stacked patch antenna element for bandwidth improvement.
FIG. 18 is a side view of the stacked patch antenna element shown in FIG. 16, and illustrating the probes that capacitively feed the patches.
FIG. 19 includes an exemplary line graph of return loss in decibels versus frequency from 3.30 GHz to 4.20 GHz for the stacked patch antenna element shown in FIG. 16.
FIG. 20 includes an exemplary line graph of return loss in decibels versus Theta from -180 degrees to 180 degrees for the stacked patch antenna element shown in FIG. 16 at Phi = 0 degrees at frequencies of 3.3 GHz, 3.4 GHz, 3.5 GHz, 3.6 GHz, 3.7 GHz, 3.8 GHz, 3.9 GHz, 4 GHz, 4.1 GHz, and 4.2 GHz.
FIG. 21 illustrates an example antenna array or MIMO antenna assembly including sixteen total stacked patch antenna elements shown in FIG. 16.
FIG. 22 is a side view of the antenna array or MIMO antenna assembly shown in FIG. 21, and illustrating isolation rails.
FIGS. 23 and 24 are exemplary line graphs of return loss in decibels versus Theta from -180 degrees to 180 degrees for the antenna array or MIMO antenna assembly shown in FIG. 21 without isolation rails (FIG. 23) and with isolation rails (FIG. 24) at Phi = 0 degrees at frequencies of 3.3 GHz, 3.4 GHz, 3.5 GHz, 3.6 GHz, 3.7 GHz, 3.8 GHz, 3.9 GHz, 4 GHz, 4.1 GHz, and 4.2 GHz.
FIG. 25 is an exploded perspective views of a stacked patch antenna element including an upper patch, a lower patch, an isolation fence, a dielectric patch carrier, and a dielectric carrier with snap features to attach and support feed probes for SMT (surface-mount technology) processing according to an exemplary embodiment.
FIG. 26 is a perspective view of the stacked patch antenna element shown in FIG. 25 after being assembled such that the upper and lower patches are coupled to the dielectric patch carrier and such that the isolation fence is disposed generally around the upper and lower patches.
FIG. 27 is an exploded perspective views of a stacked patch antenna element including an upper patch, a lower patch, an isolation fence, a dielectric patch carrier, and a dielectric carrier with snap features to attach and support feed probes for SMT (surface-mount technology) processing according to an exemplary embodiment.
FIG. 28 is a perspective view of the stacked patch antenna element shown in FIG. 27 after being assembled such that the upper and lower patches are coupled to the dielectric patch carrier and such that the isolation fence is disposed generally around the upper and lower patches.
FIG. 29 is an exploded perspective views of a stacked patch antenna element including an upper patch, a lower patch, an isolation fence with wave solder tabs, and a dielectric carrier with snap features to attach and support feed probes, the upper patch, and the lower patch according to an exemplary embodiment.
FIG. 30 is a perspective view of the stacked patch antenna element shown in FIG. 29 after being assembled such that the feed probes, the upper patch, and the lower patch are coupled to the dielectric carrier and such that the isolation fence is disposed generally around the upper and lower patches.

Corresponding reference numerals indicate corresponding (although not necessarily identical) parts throughout the several views of the drawings.

### DETAILED DESCRIPTION

Example embodiments will now be described more fully with reference to the accompanying drawings.

The evolution of data networks to the next or higher generation telecommunication standards (*e*.*g*., from 4^{th} generation (4G) to 5^{th} generation (5G), *etc*.) will require an increase in antenna density and beam steering technology to fulfill the data throughput requirements. For example, massive radio and antenna systems may be implemented in order to meet the higher data throughput requirements for the network upgrade from 4G to 5G.

In a massive MIMO antenna assembly, multiple antenna elements work in tandem to provide beam scanning functionality. A typical massive MIMO antenna array may include a very large number of antenna elements, such as 20 to 2000 antenna elements. With such a large number of antenna elements, there must be sufficient isolation between the antenna elements for good performance. Also, the radiation characteristics of each antenna element should be similar regardless of the location within the array. Because of the large number of antenna elements, overall cost of a massive MIMO antenna assembly may be reduced by enabling the implementation for full automation of the assembly process using traditional manufacturing techniques.

Accordingly, disclosed herein are exemplary embodiments of stacked patch antenna elements, including SMT (surface-mount technology) stacked patch antenna elements, THT (through-hole technology) stacked patch antenna elements, stacked patch antenna elements that allow for wave soldering, *etc.* Also disclosed herein are exemplary embodiments of antenna assemblies (*e*.*g*., MIMO antenna assemblies, single antenna element assemblies, *etc*.) that include one or more stacked patch antenna elements. Exemplary methods of manufacturing or assembling stacked patch antenna elements and antenna assemblies are also disclosed herein.

In an exemplary embodiment, a stacked patch antenna element generally includes upper and lower (or top and bottom) patches. The upper and lower patches are configured to be coupled to a dielectric carrier (*e*.*g*., a plastic carrier, *etc*.) and positioned within an electrically-conductive isolation box or fence (broadly, electrically-conductive walls or structure), such the electrically-conductive walls or structure of the isolation box or fence are disposed generally about or around the upper and lower patches.

The stacked patch antenna element may be configured for use as a surface-mount device (SMD) that is compatible with surface-mount technology (SMT). For example, the lower or bottom patch may include SMT/solder tabs or legs operable as feed probes when the SMT/solder tabs are placed directly on the surface of the PCB and soldered to corresponding electrically-conductive portions (*e*.*g*., pads, traces, feeds, *etc*.) along the surface of the PCB. Also, for example, the isolation box or fence may include SMT/solder tabs or legs for grounding and mechanical connection when the SMT/solder tabs or legs are placed directly on the surface of the PCB and soldered to corresponding portions (*e*.*g*., ground, mechanical attachment points, *etc*.) along the surface of the PCB.

Alternatively, the stacked patch antenna element may be configured to be compatible with through-hole technology. For example, the lower or bottom patch may include tabs or legs configured to be positioned at least partially within or entirely through corresponding holes (broadly, openings) in the PCB. The tabs or legs of the lower patch may be inserted into through holes or thru-holes in the PCB from a first side of the PCB and then soldered to corresponding electrically-conductive portions (*e*.*g*., pads, traces, feeds, *etc*.) along a second side of the PCB opposite the first side. Also, for example, the isolation box or fence may include tabs or legs for grounding and mechanical connection that are configured to be positioned at least partially within or entirely through corresponding holes in the PCB. The tabs or legs of the isolation box or fence may also be inserted into through holes or thru-holes in the PCB from the first side of the PCB and then soldered to corresponding portions (*e*.*g*., ground, mechanical attachment points, *etc*.) along the second side of the PCB opposite the first side.

As yet another example, a stacked patch antenna element may be configured to be compatible with wave soldering. For example, the stacked patch antenna element may include an isolation fence with wave solder tabs and feed probes with wave solder tabs.

In an exemplary embodiment, a MIMO antenna assembly generally includes antenna elements (*e*.*g*., stacked patch antenna elements, *etc*.) within electrically-conductive boxes or fences and at least one electrically-conductive rail or isolation wall extending between at least a pair or subarray of the antenna elements. For example, the MIMO antenna assembly may include one or more rows of one or more subarrays where each subarray includes at least two stacked patch antenna elements. In this example, an electrically-conductive rail may extend along each row of the subarrays generally between the first and second stacked patch antenna elements in each subarray. The electrically-conductive boxes/fences and rails are configured to provide isolation between the antenna elements. The electrically-conductive rails may also be configured to provide for mechanical support of the MIMO antenna assembly when attached to a filter, radio, or other assembly. The antenna elements may be positioned along a top layer of a multilayer PCB. The multilayer PCB may include a feed network (*e*.*g*., a strip feedline network, transmission line network, electrically-conductive traces, *etc.*) and a calibration network along an inner layer of the multilayer PCB.

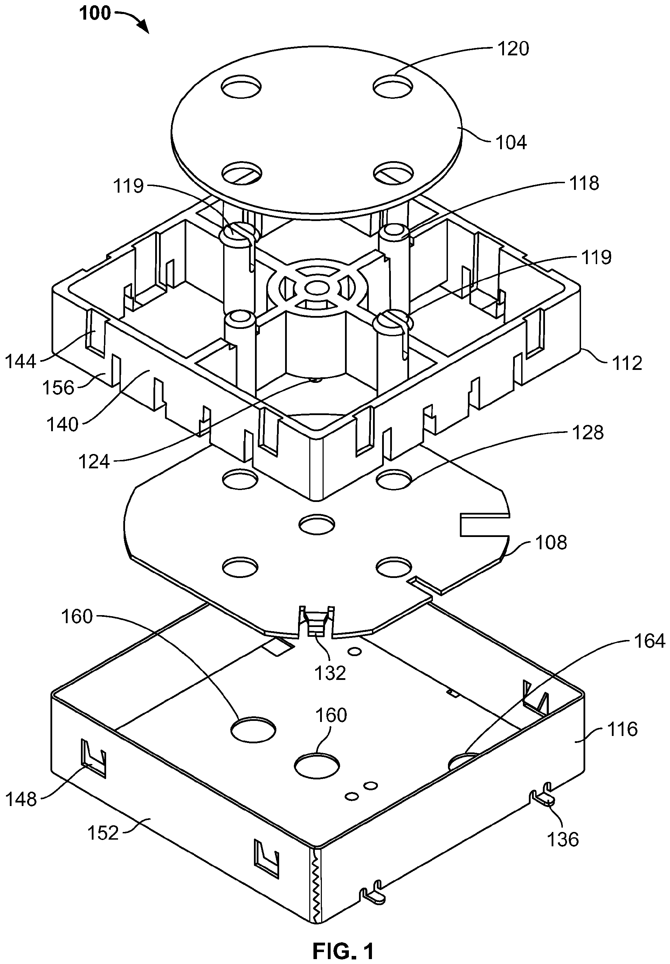

With reference to the figures, FIGS. 1, 2, and 3 illustrate an example embodiment of a stacked patch antenna panel antenna 100 embodying one or more aspects of the present disclosure. As shown, the stacked patch antenna element 100 includes a top or upper patch 104, a bottom or lower patch 108, a dielectric carrier 112, and an isolation box or fence 116.

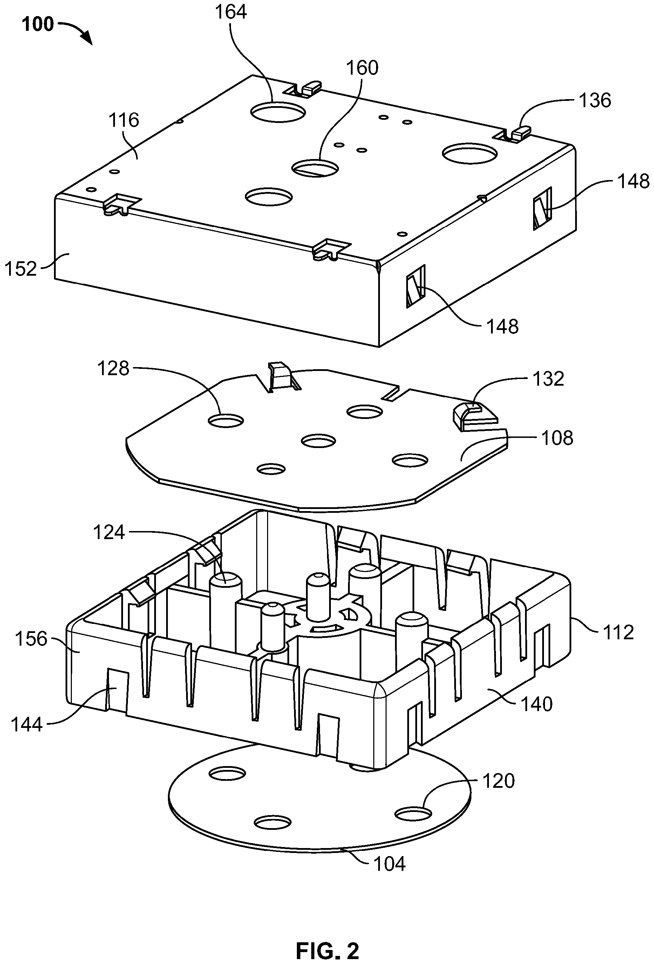

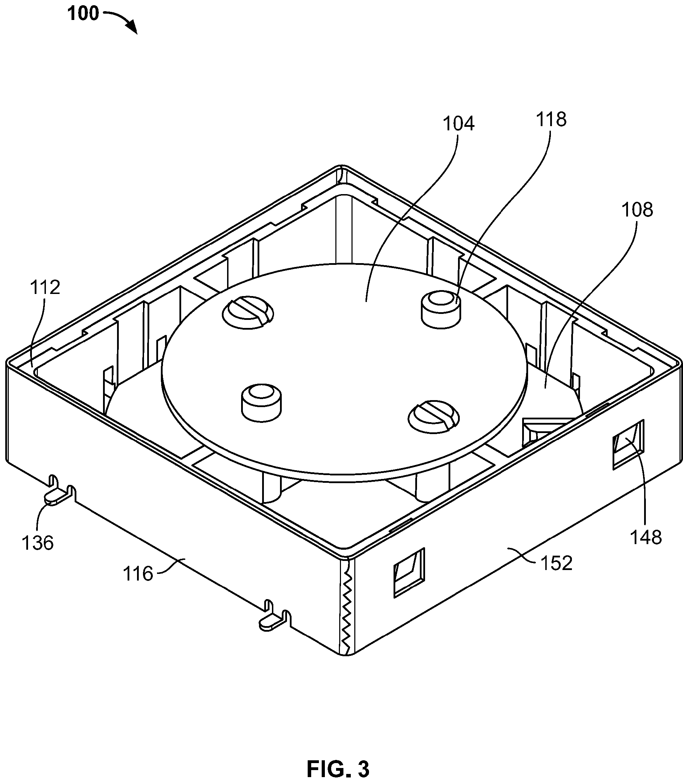

The upper and lower patches 104, 108 are configured to be mechanically coupled (*e*.*g*., via integrated snap in features or fasteners, *etc*.) to or along opposite upper and lower sides of the dielectric carrier 112. As shown in FIG. 1, the dielectric carrier 112 includes upper posts or stakes 118 (broadly, supports or members) configured to be received (*e*.*g*., snapped into, press fit, interference fit, *etc*.) within thru holes 120 (broadly, openings) in the upper patch 104 to thereby align the upper patch 104 with the dielectric carrier 112 (FIG. 3). As shown in FIG. 2, the dielectric carrier 112 includes lower posts or stakes 124 (broadly, supports or members) configured to be received within thru holes 128 (broadly, openings) in the lower patch 108 to thereby align the lower patch 108 with the dielectric carrier 112.The isolation box 116 also includes holes 160 (broadly, openings) configured for receiving the lower posts or stakes 124. In this example, the isolation box 116 includes two holes 160 for respectively receiving the inner or middle post 124 and one of the outer posts 124 to thereby align the isolation box 116 with the dielectric carrier 112.

The upper and lower posts 118, 124 extend upwardly and downwardly (broadly, outwardly) from the respective upper and lower sides of the dielectric carrier 112. The posts 118, 124 may be configured to allow the respective patches 104, 108 to be positioned onto the posts 118, 124 of the dielectric carrier 112 such that the patches 104, 108 are aligned relatively to the dielectric carrier 112.

As shown in FIG. 1, two upper posts 118 include retention members 119 for assembling and retaining the upper patch 104 to the dielectric carrier 112, *e.g.,* without using mechanical fasteners or adhesive, *etc.* Each retention member 119 may comprise spaced apart locking snaps or latching surfaces along fingers of the post 118, which fingers are separated by a slot. The slot allows the fingers to be moved inwardly toward each other when the upper patch 104 is moved, pressed, pushed, *etc.* relatively downward onto the dielectric carrier 112. Top portions of the retention members 119 may operate as camming surfaces to urge the fingers of the retention members 148 inwardly toward each other thereby reducing their perimeter size and allowing for insertion through the holes 120 in the upper patch 104. The fingers of the retention members 119 may be generally resilient, which resiliency urges the fingers to their original or initial positioning such that after the free ends of the fingers have moved past the upper patch 104, the resilient nature of the fingers may cause the fingers to move (*e*.*g*., snap back, recoil or spring back into shape after bending, *etc*.) generally over and into engagement with corresponding portions of the upper patch 104. At which point, the retention members 119 are engaged with the upper patch 104, thereby retaining the relative positioning of the upper patch 104 with the dielectric carrier 112. In some exemplary embodiments, a tactile and/or audible indication (*e*.*g*., a click, *etc*.) may be produced when the retention members 119 move over and into engagement with the upper patch 104. Advantageously, the upper patch 104 may be held or retained in place on the dielectric carrier 112 solely by the retention members 119 of the posts 118, *e.g.,* without requiring any mechanical fasteners or adhesive between the dielectric carrier 112 and the upper patch 104, *etc.*

In this exemplary embodiment, the upper patch 104 includes four holes 120 spaced apart (*e*.*g*., radially, circumferentially, *etc*.) from each other. The dielectric carrier 112 includes four upwardly extending posts 118 along the upper side of the dielectric carrier 112. The lower patch 108 includes five holes 128. The dielectric carrier 112 includes five downwardly extending posts 124 along the lower side of the dielectric carrier 112. The five holes 128 of the lower patch 108 include four outer holes spaced apart (*e*.*g*., radially, circumferentially, *etc*.) from each other and spaced around a fifth inner hole. The inner hole may be at about a middle or center of the lower patch 108. Alternative embodiments may be configured differently, e.g., with more or less holes and posts and/or at other locations, *etc.*

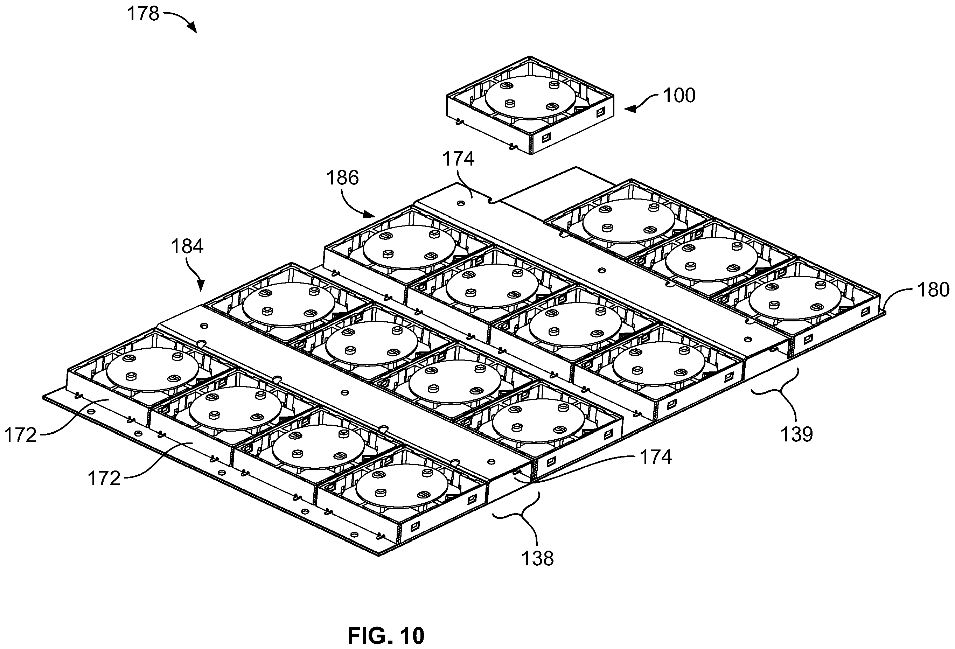

The lower patch 108 includes one or more SMT/solder tabs or legs 132 operable as feed probes. The tabs 132 align with and extend through holes 164 (broadly, openings) in the bottom of the isolation box 116. The tabs 132 of the lower patch 108 may be soldered to and thereby electrically connected with corresponding electrically-conductive portions (*e*.*g*., pads, *etc*.) along a surface of a PCB (*e*.*g*., PCB 180 shown in FIG. 10, *etc*.)*.* Alternatively, the stacked patch antenna element 100 may be configured to be compatible with through-hole technology. For example, the tabs or legs 132 of the lower patch 108 may be configured to be positioned at least partially within or entirely through corresponding holes (broadly, openings) in the PCB. The tabs or legs 132 of the lower patch 108 may be inserted into through holes or thru-holes in the PCB from a first side of the PCB and then soldered to corresponding electrically-conductive portions (*e*.*g*., pads, traces, feeds, *etc*.) along a second side of the PCB opposite the first side.

The SMT/solder tabs or legs 132 may comprise integral portions of the lower patch 108. For example, the tabs 132 may comprise portions of the lower patch 108 that have been stamped and formed (*e.g.,* bent, folded, deformed, *etc*.) downwardly for contacting corresponding feed locations 136 of the isolation box 116.

By way of example, the upper and lower patches 104, 108 may be made of solderable material (*e.g.,* tin plated steel, brass, beryllium copper, *etc*.) that is stamped to provide the overall shape and thru holes 120, 128. Portions of the stamped material for the lower patch 108 may also be formed (*e.g.,* bent, folded, deformed, *etc*.) to provide the SMT tabs 132. Alternatively, other electrically-conductive materials and/or other manufacturing processes besides stamping and forming may be used for either or both patches 104, 108.

As shown in FIG. 1, the isolation box 116 include SMT/solder tabs or legs 136 for grounding and mechanical connection. The tabs 136 may be configured to align with and be soldered to corresponding grounding locations of a PCB (*e.g.,* PCB 180 shown in FIG. 10, *etc*.) when the isolation box 116 is positioned along a PCB including the grounding locations. Alternatively, the stacked patch antenna element 100 may be configured to be compatible with through-hole technology, wave soldering, *etc.* For example, the tabs or legs 136 of the isolation box 116 may be configured to be positioned at least partially within or entirely through corresponding holes (broadly, openings) in the PCB. The tabs or legs 136 of the isolation box 116 may be inserted into through holes or thru-holes in the PCB from a first side of the PCB and then soldered to corresponding electrically-conductive (*e.g.,* ground, mechanical attachment points, *etc*.) along the second side of the PCB opposite the first side.

The SMT/solder tabs or legs 136 may comprise integral portions of the isolation box 116. For example, the tabs 136 may comprise portions of the isolation box 116 that have been stamped and formed (*e.g.,* bent, folded, deformed, *etc*.)*.*

The dielectric carrier 112 may be configured (*e.g.,* sized, shaped, *etc*.) relative to the isolation box 116 such that positioning the dielectric carrier 112 within the isolation box 116 positions the SMT/solder tabs or legs 132 of the lower patch 108 through the openings 164 in the bottom of the isolation box 116. In some exemplary embodiments, the dielectric carrier 112 may be configured (*e.g*., sized, shaped, *etc*.) relative to the isolation box 116 such that the dielectric carrier 112 is positionable only within the isolation box 116 in a single orientation in which the SMT tabs 132 of the lower patch 108 will be aligned with and extend through the openings 164 of the isolation box 116. In such embodiments, the dielectric carrier 112 may be configured (*e*.*g*., sized, shaped, *etc*.) such that the dielectric carrier 112 is not able to be positioned within the isolation box 116 in any orientation in which the SMT tabs 132 of the lower patch 108 will be misaligned with and not extend through the openings 164 in the bottom of the isolation box 116.

The dielectric carrier 112 and the isolation box 116 may include a latching or snap fit mechanism for mechanically coupling (*e*.*g*., latching, snap fitting, *etc.)* the dielectric carrier 112 to the isolation box 116. For example, one or more sidewalls 140 of the dielectric carrier 112 may include one or more openings 144 configured to engagingly receive one or more latching members or tabs 148 (broadly, portions) along one or more sidewalls 152 of the isolation box 116. When the dielectric carrier 112 is moved, pressed, pushed, *etc.* relatively downward into the isolation box 116, the lower portions 156 of the dielectric carrier's sidewalls 140 beneath the openings 140 may operate as camming surfaces to urge the latching members 148 of the isolation box 116 outwardly away from the dielectric carrier 112. The sliding contact of the latching members 148 along the inner surfaces of the sidewall portions 156 of the dielectric carrier 112 may cause the latching members 148 to flex, deform, move, pivot, or cam outwardly from their original or initial position. The latching members 148 may be generally resilient (*e.g.,* stamped and folded sheet metal, *etc*.)*,* which resiliency urges the latching members 148 to return to their original or initial positioning such that after the free ends of the latching members 148 have moved past the lower sidewall portions 156 and into the openings 144 of the dielectric carrier 112, the resilient nature of the latching members 148 may cause the latching members 148 to move (*e*.*g*., snap back, recoil or spring back into shape after bending, *etc*.) generally over and into engagement with corresponding portions (*e*.*g*., engagement, latching, or locking surfaces, *etc*.) along the bottom of the openings 144. At which point, the latching members 148 are engaged and retained within the openings 144 of the dielectric carrier 112, thereby retaining the relative positioning of the dielectric carrier 112 within the isolation box 116. In some exemplary embodiments, a tactile and/or audible indication (*e*.*g*., a click, *etc*.) may be produced when the latching members 148 move over and into engagement with the bottom portions 156 of the openings 144 of the dielectric carrier 112.

In some exemplary embodiment, the dielectric carrier 112 may also be configured (*e.g.,* sized, shaped, *etc*.) relative to the isolation box 116 such that the dielectric carrier 112 snugly fits, press fits, friction fits, interference fits, *etc.* within the isolation box 116.

In exemplary embodiments that include a plurality (*e*.*g*., an array, *etc*.) of stacked patch antenna elements 100, the isolation boxes 116 may be placed along and/or electrically coupled with a relatively large ground plane common to all the SMT stacked patch antenna elements 100. The isolation boxes 116 may have a generally rectangular or non-rectangular shape (*e*.*g*., triangular or hexagonal when viewed from above, *etc*.) depending on the particular configuration of the antenna assembly or system (*e*.*g*., antenna array or panel assembly, *etc*.) in which it will be used.

In addition, the walls of an isolation box 116 may also be different on different sides. For example, the walls of an isolation box 116 may vary in height and/or shape. In addition, one or more horizontal, vertical, diagonal, *etc.* slots may be provided in one or more walls of an isolation box 116 to change the mutual coupling between the patches or radiating elements. One or more walls of an isolation box 116 may be configured to slanted and non-perpendicular to a ground plane.

By way of example, the isolation box 116 may be made of solderable material (*e*.*g*., tin plated steel, brass, beryllium copper, *etc*.) that is stamped to provide the overall shape, openings 160, *etc.* Portions of the stamped material may then be formed (*e*.*g*., bent, folded, deformed, *etc*.) to provide the SMT tabs 136, latching members 148, and sidewalls 152. Alternatively, other electrically-conductive materials and/or other manufacturing processes besides stamping and forming may also be used for the isolation box 116.

In exemplary embodiments including a plurality of SMT stacked patch antenna elements 100, the sidewalls 152 of the isolation boxes 116 help to reduce mutual coupling between the patches 104, 108 within the different isolation boxes 116. In various exemplary embodiments, the sidewalls 152 of the isolation boxes 116 may be sufficiently high so as to obscure the direct path from patches 104, 108 within a first isolation box 116 to patches 104, 108 within a second isolation box 116. For example, in various exemplary embodiments, the walls 152 of an isolation box 116 may be at least as tall as the top patch disposed within the isolation box 116. For example, the walls 152 may have a height above a ground plane at least as high as a distance between the upper patch 104 and the ground plane. Or, for example the walls 152 may extend higher over the ground plane than the upper patch 104. As yet another example, the top of the walls 152 may be lower than or below the upper patch 104.

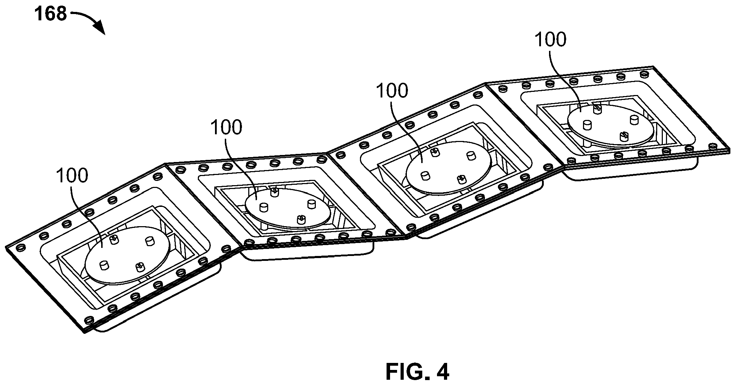

In exemplary embodiments, the SMT stacked patch antenna elements 100 may be placed in a tape and reel package for automatic placement, e.g., fully automated SMT assembly, *etc.* For example, FIG. 4 illustrates an exemplary "tape and reel" packaging 168 that includes four stacked patch antenna elements 100. The stacked patch antenna elements 100 are positioned within pockets or cavities along the tape and reel packaging 168. A cover (*e*.*g*., a peel-back cover, *etc*.) is disposed over and covers the stacked patch antenna elements 100. The stacked patch antenna elements 100 may also be packaged in tray form for automatic placement by pick and place equipment and SMT or THT soldering processes.

Exemplary embodiments of the stacked patch antenna elements disclosed herein may provide one or more (but not necessarily any or all) of the following advantages or features, such as low cost, less components to fail, low assembly tooling cost, reduced assembly time, reduced manual labor required for assembly, and/or repeatability of assembly process. In exemplary embodiments, snap and/or integral features are used for assembling the components of the stacked patch antenna element, which reduces (*e*.*g*., eliminates, *etc*.) the need for additional mechanical fasteners. In exemplary embodiments, stacked patch antenna elements may be arrayed along a PCB for a Multi-MIMO scanning array. In other exemplary embodiments, a stacked patch antenna element may be used in a single element application.

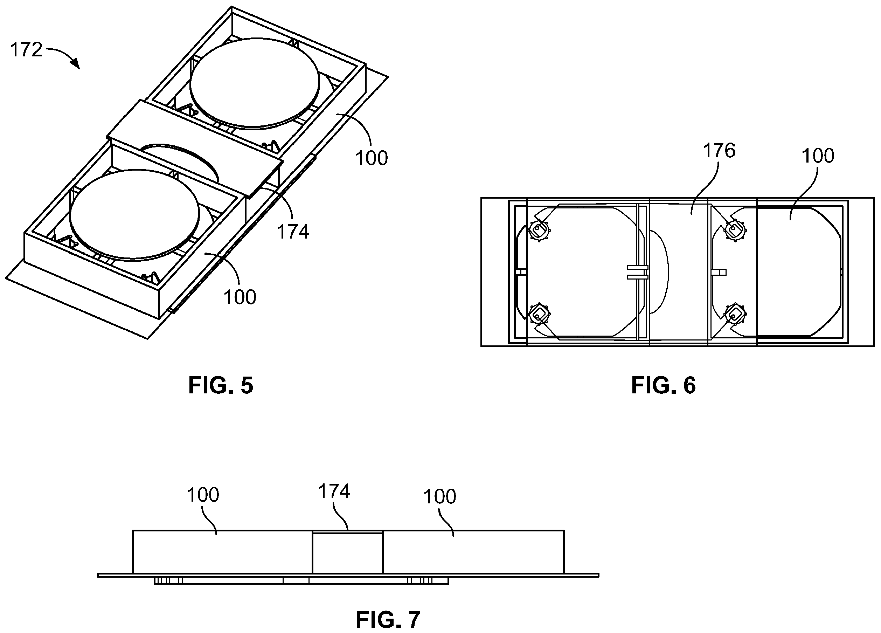

FIGS. 5, 6, and 7 illustrate an exemplary embodiment of a subarray or assembly 172 that includes two stacked patch antenna elements 100 as shown in FIGS. 1, 2, and 3. An example feeding network 176 for the subarray 172 is shown in FIG. 6.

In this example, the subarray 172 includes two stacked patch antenna elements 100 arrayed in a vertical plane such that the subarray 172 may achieve about 70 to 100 degree azimuth beam width and about 30 to 45 degree elevation beam width. The subarray 172 may have two (+/- 45 degrees) linear polarizations. The stacked patch antenna elements 100 may be placed relatively close to each other in the horizontal plane with about 0.5 to 0.7 wavelength spacing. Advantageously, the closer the stacked patch antenna elements 100 are placed to each other the larger scan angle for the subarray 172.

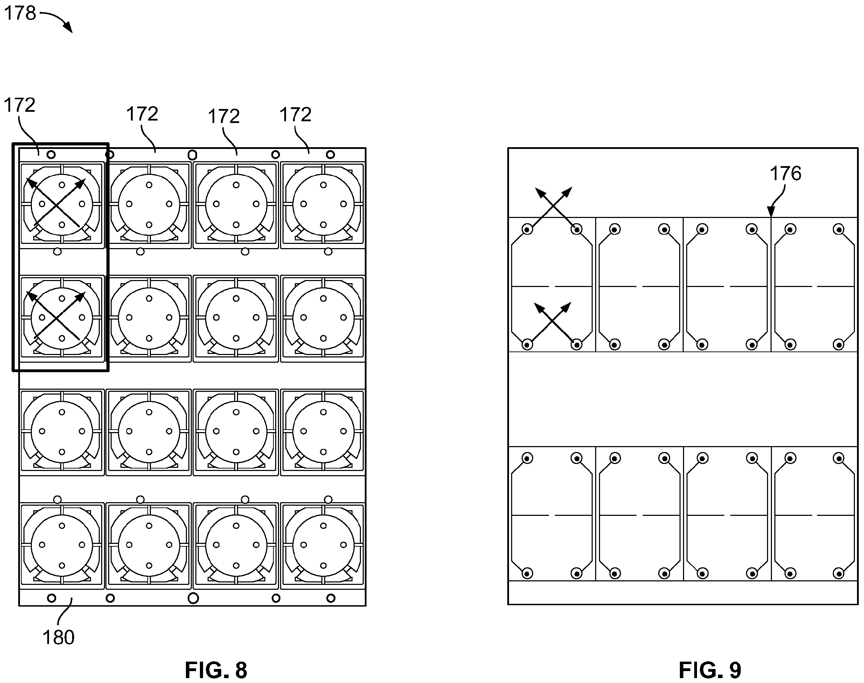

FIGS. 8 and 9 illustrate an exemplary embodiment of an antenna array or MIMO antenna assembly 178 that includes two rows each with four subarrays 172 as shown in FIG. 5. Accordingly, the MIMO antenna assembly 178 includes a total of eight subarrays 172 and thus sixteen total stacked patch antenna elements 100. The exemplary printed circuit board 180 may include a feed network with the sixteen total ports as here are two polarizations (dual slant polarization) for each of the eight subarrays 172. FIG. 9 illustrates an exemplary feed network 176 for the subarrays 172, which may be plastic with a metallized top, *etc.* Accordingly, this exemplary embodiment provides an example of a 16 x 16 MIMO antenna array 178.

As shown in FIG. 10, the stacked patch antenna elements 100 (FIGS. 1 to 3) may be positioned along the multilayer printed circuit board (PCB) 180. The multilayer PCB 180 may include a feed network and a calibration network on an inner layer of the multilayer PCB 180. The stacked patch antenna elements 100 may be coupled to the multilayer PCB 180 by soldering the SMT/solder tabs 132 of the lower patch 108 to electrically-conductive portions (*e*.*g*., pads, *etc*.) along the PCB 180 and by soldering the SMT solder tabs or legs 136 of the isolation boxes 116 to electrically-conductive portions (*e*.*g*., grounding portions, *etc*.) along the PCB 180.

In this illustrated embodiment, the MIMO antenna assembly 178 includes first and second rows 184 and 186 of four subarrays 172 where each subarray 172 includes two stacked patch antenna elements 100. According, this is therefore a 16 x 16 MIMO example. In alternative embodiments, the MIMO antenna assembly 178 may be configured differently, such as with a 4x4 array, 8x8 array, *etc.* The MIMO antenna assembly 178 may have more or less than sixteen stacked patch antenna elements and/or have a different antenna element arrangement (*e*.*g*., a larger or smaller array of stacked patch antenna elements, a non-rectangular array, a linear array, *etc*.)*.* Or, for example, the MIMO antenna assembly 178 may include one or more stacked patch antenna elements different than the stacked patch antenna elements 100 disclosed herein.

As shown in FIG. 10, the MIMO antenna assembly 178 includes electrically-conductive rails 174 (broadly, electrically-conductive members) that are configured to provide isolation between the stacked patch antenna elements and to add stiffness to the MIMO antenna assembly 178. The rails 174 may also provide for mechanical support of the MIMO antenna assembly 178, such as when the assembly 178 is attached to a filter, radio, or other assembly.

With continued reference to FIG. 10, a first rail 174 extends generally along the first row 184 between the first and second stacked patch antennas 100 of each subarray 172 in the first row 184. A second rail 174 extends generally along the second row 186 between the first and second stacked patch antennas 100 in each subarray 172 of the second row 186. In some exemplary embodiments, the MIMO antenna assembly 178 may further include a third or center rail that extends generally between the first and second rows 184, 188 for improved isolation.

The first rail 174 may be configured (*e*.*g*., sized, shaped, *etc*.) relative to the gap or spaced distance 138 separating the first and second stacked patch antenna elements 100 within the first row 184 such that the first rail 174 snugly fits, press fits, friction fits, interference fits, *etc.* within the gap or spaced distance 138. Similarly, the second rail 174 may be configured (*e*.*g*., sized, shaped, *etc*.) relative to the gap or spaced distance 139 separating the first and second stacked patch antenna elements 100 within the second row 186 such that the second rail 174 snugly fits, press fits, friction fits, interference fits, *etc.* within the gap or spaced distance 139.

The isolation rails 174 may be attached to the stacked patch antenna elements 100 and/or to the PCB 180 by using mechanical fasteners (*e*.*g*., screws and spacers, *etc*.) or an automated soldering process, *etc.* Alternatively, the rails 174 may be configured to be snap fit into the respective gaps 138, 139 such that the rails 174 are held or retained in place relative to the isolation boxes 116 solely by the friction or interference fit created between the rails 174 and the corresponding sidewalls 140 of the isolation boxes 116, e.g., without requiring any adhesive, solder, mechanical fasteners, *etc.* between the rails 174 and the isolation boxes 116, *etc.*

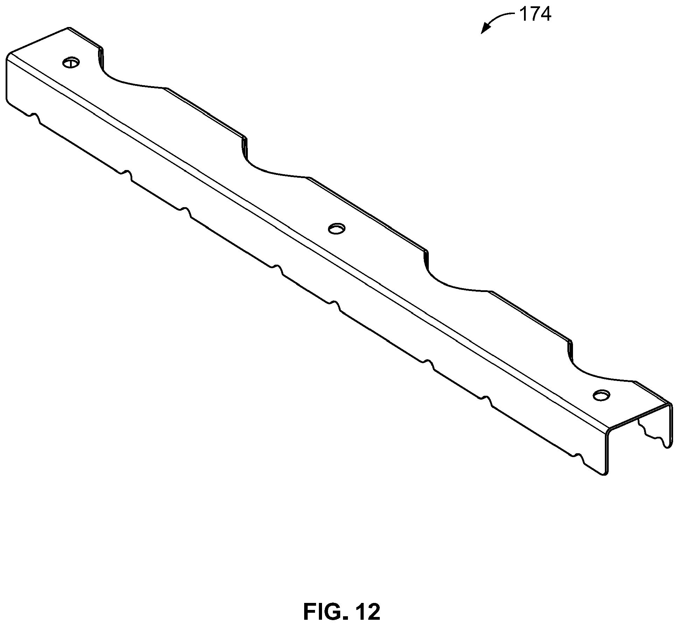

FIG. 12 illustrates an example isolation rail 174 that may be used with the MIMO antenna assembly 178. As shown, the isolation rail 174 may include a generally horizontal upper portion between two downwardly extending leg portions. The leg portions may be generally perpendicular to the upper connecting portion such that the isolation rail 174 has a generally inverted U shaped profile or a C shaped profile. Accordingly, the isolation rail 174 may comprise a C channel member or structure. In some exemplary embodiments, the isolation rail 174 may be made of aluminum that is stamped and formed (*e*.*g*., bent, folded, deformed, *etc*.)*.* Alternatively, other electrically-conductive materials besides aluminum and/or other manufacturing processes besides stamping and forming may be used for an isolation rail 174.

The multilayer PCB 180 may comprise a 4-layer radio frequency (RF) PCB including top and bottom layers (*e*.*g*., ground plane layers, *etc*.) and two inner layers (*e*.*g*., signal layers, *etc*.) disposed generally between the top and bottom layers. Either or both of the inner layers may include electrically-conductive traces (*e*.*g*., copper traces, *etc*.) defining the feed network (*e*.*g*., a strip feedline network, *etc*.) and a calibration network, *e.g.,* as shown in FIG. 9, *etc.* The PCB 180 may be made from various materials, such as PTFE based PCB materials, ceramic loaded substrates, FR4, *etc.* The PCB 180 may also include more or less than four layers in other exemplary embodiments. In exemplary embodiments, the multilayer PCB 180 may include coupling traces, power dividers, and feeding networks. The multilayer PCB 180 may include pads for soldering resistors, shielding boxes, element feeds, connectors, *etc.* The PCB 180 may further include mounting holes and other mechanical attachment points for attachment to an antenna filter or radio module, which may be assembled onto the PCB 180.

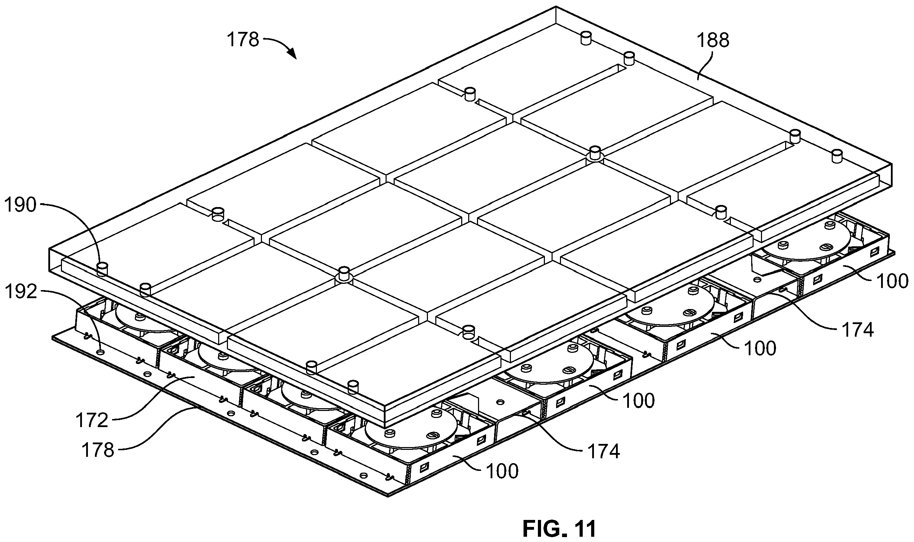

As shown in FIG. 11, the MIMO antenna assembly 178 may also include a radome 188. The radome 188 may be made of a dielectric material, such as polycarbonate, other dielectric material, *etc.* The radome 188 may be held in place over the PCB 180 with mechanical fasteners (not shown) positioned within thru-holes 190 (broadly, openings) of the radome 188 and thru-holes 192 (broadly, openings) of the PCB 180. Alternatively, other methods and means may be used to attach the radome 188 in addition to or besides mechanical fasteners.

FIG. 10 illustrates first and second rows 184, 186 of four subarrays 172 each including two stacked patched antenna elements 100. Alternative embodiments may include other antenna array sizes, groupings, or orientations, such as two-by-two arrays, three-by-three arrays, two-by-eight arrays, four-by-three arrays, rectangular arrays, non-rectangular arrays, triangular arrays, linear arrays, circular arrays, other groupings or arrangements of antenna elements that are not in an array, *etc.* Alternative embodiments may include other antenna element or radiator configurations and types besides the illustrated stacked patch antenna elements 100, such as non-circular patches and/or non-patch antenna elements.

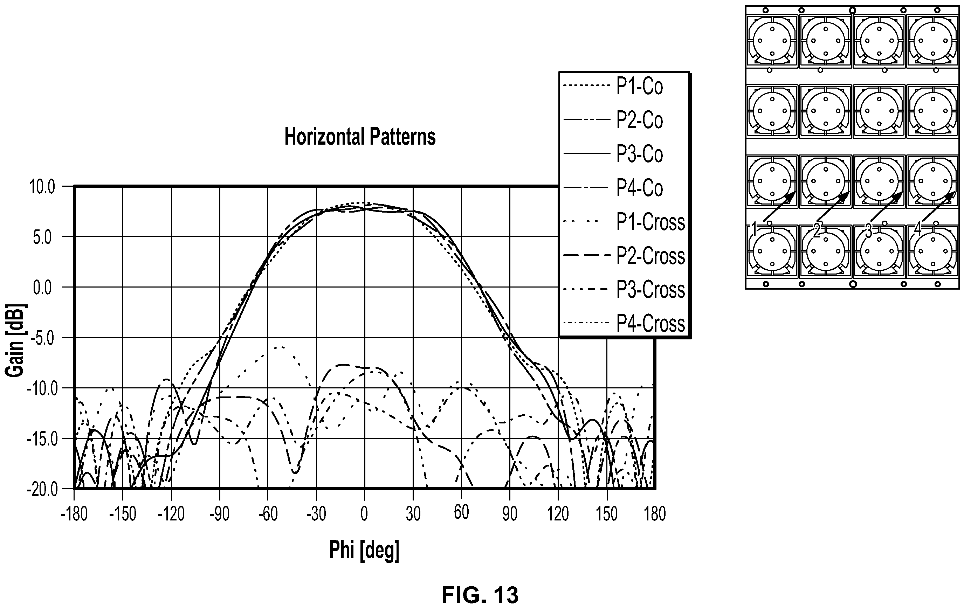

FIGS. 13, 14, and 15 provide analysis results for an exemplary embodiment of an MIMO antenna assembly as shown in FIGS. 8 through 11. The MIMO antenna assembly included two rows of four subarrays each where each subarray included two stacked patch antenna elements. Accordingly, the MIMO antenna assembly included sixteen total stacked patch antenna elements. These analysis results are provided only for purposes of illustration and not for purposes of limitation.

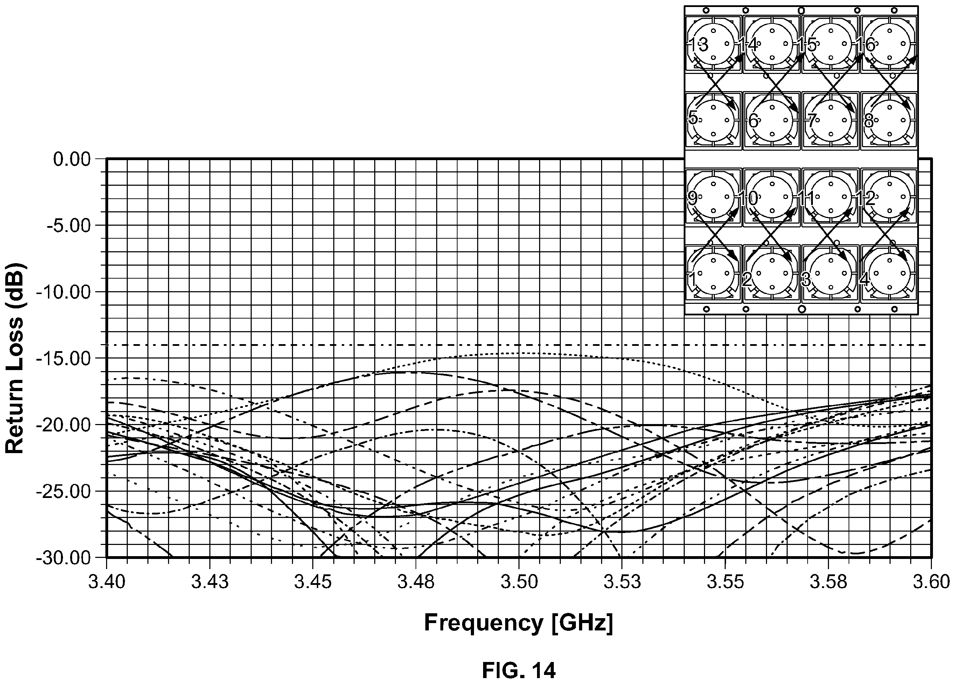

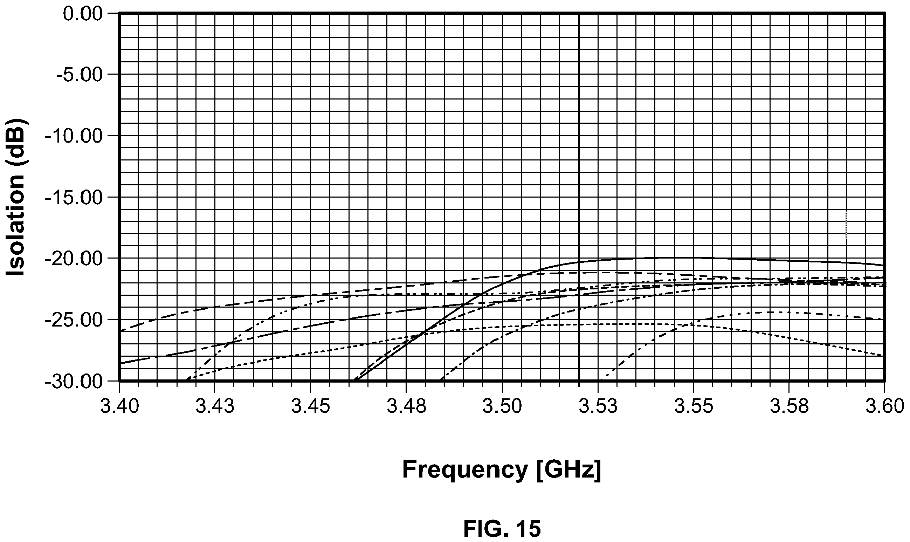

More specifically, FIG. 13 includes an exemplary line graph of horizontal radiation patterns showing gain in decibels (dB) versus Phi in degrees for a row of four stacked patch antenna elements shown in FIG. 8 and having the same polarization. FIG. 14 includes an exemplary line graph of return loss in decibels versus frequency from 3.4 Gigahertz (GHz) to 3.6 GHz for all sixteen stacked patch antenna elements shown in FIG. 8. FIG. 15 includes an exemplary line graph of isolation in decibels versus frequency from 3.4 GHz to 3.6 GHz between all eight subarrays of the stacked patch antenna elements shown in FIG. 8.

An exemplary embodiment of a MIMO antenna assembly as shown in FIGS. 8 through 11 may include the following electrical parameters. The MIMO antenna assembly may be configured to be operable within a frequency range or bandwidth from 3400 to 3800 MHz with a return loss greater than 15 dB and with an isolation greater than 19 dB. The MIMO antenna assembly may also be configured to be operable with coupling between the closest (in side) subarray ports of less than -20 dB and with coupling to all other subarray ports of less than -25 dB. The MIMO antenna assembly may be further configured to be operable with a horizontal beam width of 80 to 110 degrees, with horizontal gain deviation between all ports in horizontal plane ±60° less than or equal to 1.3 dB, with cross polar ratio for an elevation 70° ≤ θ ≤ 110°and an azimuth -60° ≤ Φ ≤ +60° of greater than or equal to 10 dB, and with horizontal element spacing of about 0.5 wavelength (λ). The electrical parameters set forth in this paragraph are provided only for purposes of illustration and not for purposes of limitation as other exemplary embodiments may be configured to be operable with one or more electrical parameters different than disclosed in this paragraph. Generally, however, this FIGS. 13 through 15 show that the MIMO antenna assembly had good performance within a frequency range from 3400 MHz to 3800 MHz.

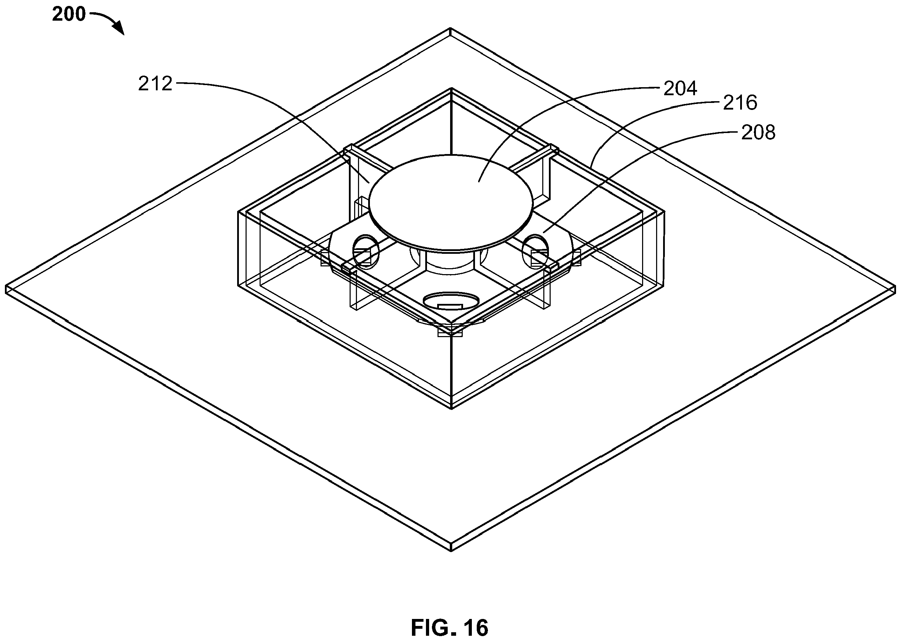

FIGS. 16, 17, and 18 illustrate an example embodiment of a stacked patch antenna panel antenna 200 embodying one or more aspects of the present disclosure. As shown, the stacked patch antenna element 200 includes a top or upper patch 204, a bottom or lower patch 208, a dielectric carrier 212, and an isolation box or fence 216.

The dielectric carrier 212 (*e*.*g*., a plastic carrier, *etc*.) may be configured for supporting the patches 204, 208 and feed probes 232. The isolation box or fence 216 may be configured to generally surround or be disposed generally about the upper and lower patches 204, 208.

The stacked patch antenna element 200 is configured to have symmetrical capacitive probes 232, *e.g.,* two probes per polarization. Alternatively, other exemplary embodiments may include one probe per polarization.

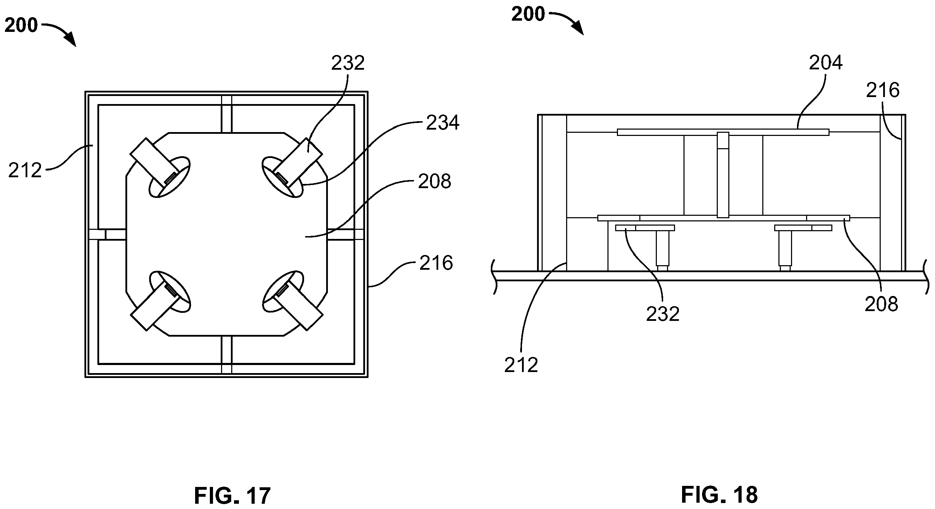

FIG. 17 illustrates an exemplary symmetrical feeding arrangement provided by the symmetrical feed probes 232 that capacitively feed the patches 204, 208. Also shown in FIG. 17 are openings 234 (*e*.*g*., cutouts, stamped portions, oval-shaped openings, *etc*.) in the lower patch 208. Each opening 234 may be disposed generally between a corresponding capacitive feed probe 232 and a center of the stacked patch antenna element 200. The openings 234 may be configured to provide a bandwidth improvement.

By way of example only, the isolation box or fence 216 may be configured to have a size of about .45 wavelength x about .45 wavelength. Stated differently, the isolation box or fence 216 may be generally rectangular or square with a length of about .45λ and a width of about .45λ. These exemplary dimensions are provided for purpose of illustration only as other exemplary embodiments may be configured differently, e.g., with a larger or smaller isolation box or fence, with a non-rectangular isolation box or fence, *etc.*

In exemplary embodiments, the stacked patch antenna element 200 may be used in a subarray (*e*.*g*., 2x1, 3x1, 4x1, *etc*.) of stacked patch antenna elements and/or arrayed along a PCB for a Multi-MIMO scanning array, *etc.* In other exemplary embodiments, the stacked patch antenna element 200 may be used in a single element application.

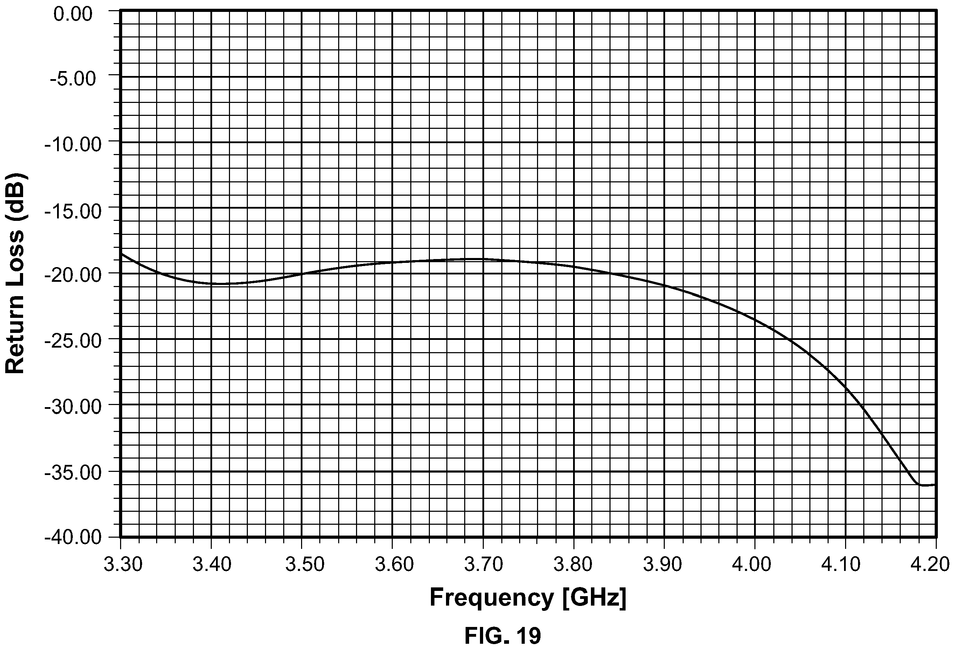

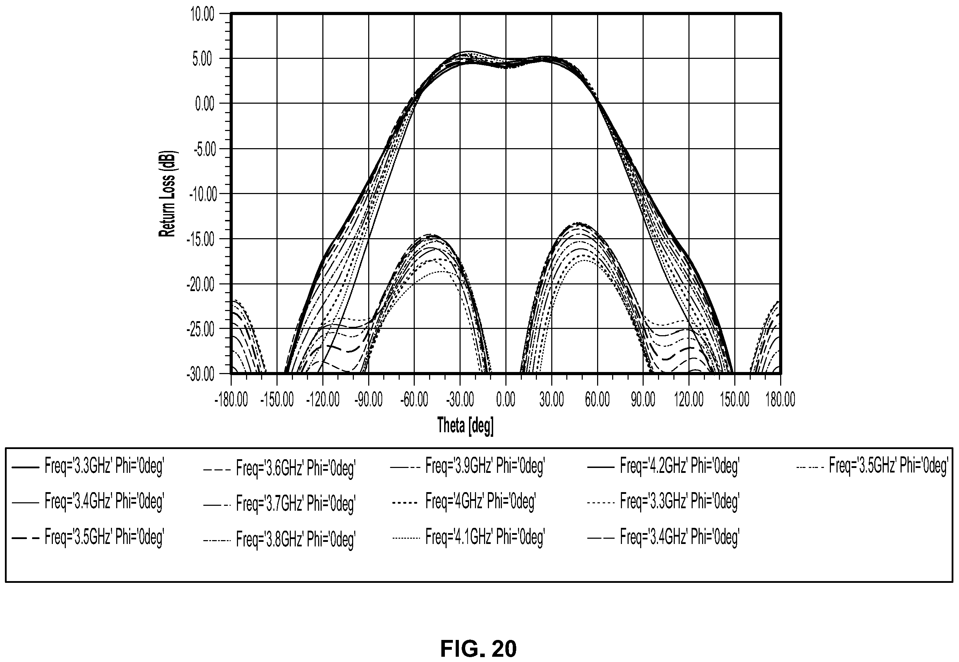

FIGS. 19 and 20 provide analysis results for the stacked patch antenna element 200 shown in FIGS. 16 through 18. These analysis results are provided only for purposes of illustration and not for purposes of limitation.

More specifically, FIG. 19 includes an exemplary line graph of return loss in decibels versus frequency from 3.30 GHz to 4.20 GHz for the stacked patch antenna element shown in FIG. 16. Generally, FIG. 19 shows that the stacked patch antenna element 200 had good return loss performance (*e*.*g*., less than -18 dB *etc*.) across a frequency range from 3.3 GHz to 4.2 GHz.

FIG. 20 includes an exemplary line graph of return loss in decibels versus Theta from -180 degrees to 180 degrees for the stacked patch antenna element shown in FIG. 16 at Phi = 0 degrees at frequencies of 3.3 GHz, 3.4 GHz, 3.5 GHz, 3.6 GHz, 3.7 GHz, 3.8 GHz, 3.9 GHz, 4 GHz, 4.1 GHz, and 4.2 GHz. Generally, FIG. 20 also shows that the stacked patch antenna element 200 had good radiation pattern performance across a frequency range from 3.3 GHz to 4.2 GHz.

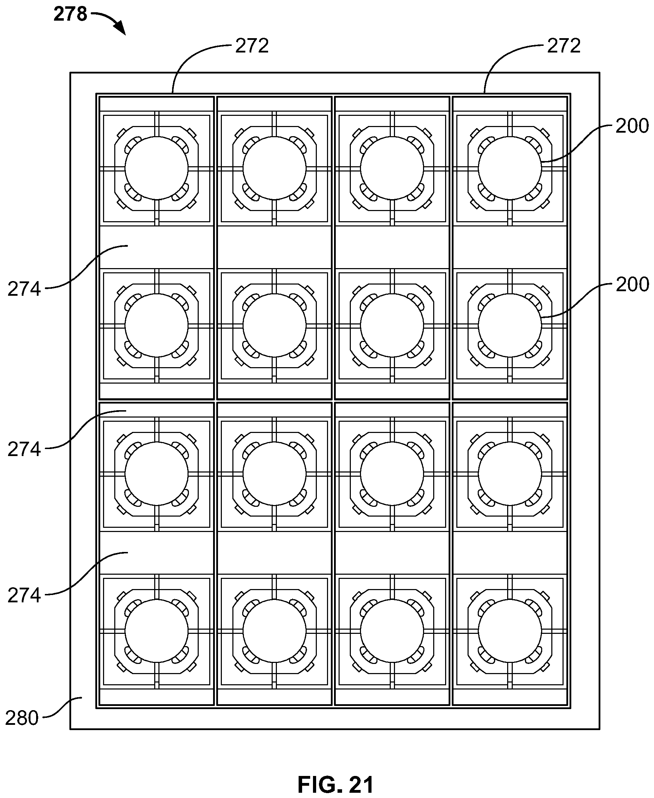

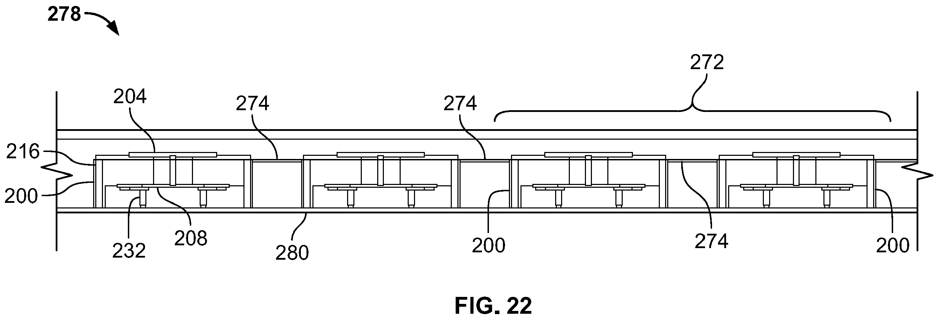

FIGS. 21 and 22 illustrates an example embodiment of a MIMO antenna assembly or antenna array 278 embodying one or more aspects of the present disclosure. As shown, the antenna assembly 278 includes eight subarrays 272 wherein each subarray 272 includes two stacked patch antenna elements 200 as shown in FIGS. 16 through 18. Accordingly, the antenna assembly 278 includes sixteen total stacked patch antenna elements 200 in this exemplary embodiment. Alternative embodiments may include a MIMO antenna assembly or antenna array having more or less than sixteen stacked patch antenna elements 200.

For each subarray or assembly 272, the two stacked patch antenna elements 200 may be arrayed in a vertical plane such that the subarray 272 may achieve about 70 to 100 degree azimuth beam width and about 30 to 45 degree elevation beam width. Each subarray 272 may have two (+/- 45 degrees) linear polarizations.

The stacked patch antenna elements 200 may be placed relatively close to each other. For example, the spacing in the azimuth plane may be within a range of about 0.5λ to about 0.7 λ (*e*.*g*., 0.5λ, 0.7 λ, 0.6λ, *etc*.). The spacing in the elevation plane may be about 0.7 λ such that a choke/pocket is created generally between the isolation boxes 216 of the elements 200 in the elevation plane. The space between the elements 200 may create cavity resonance and pattern performance may be poor. To help avoid or alleviate this cavity resonance issue, isolation rails/walls 274 may be placed in between the elements 200 to shorten the distance to ground.

In the illustrated embodiment shown in FIG. 22, the isolation walls 274 have the same height as the isolation boxes 216. Alternatively, the isolation walls 274 may be optimized +/- X millimeters for better or optimal performance.

The feed probes 132 may be soldered to and thereby electrically connected with corresponding electrically-conductive portions (*e*.*g*., pads, *etc*.) along a surface of a PCB 280 (FIG. 22). The printed circuit board 280 may include a feed network with sixteen total ports with two polarizations (dual slant polarization) for each of the eight subarrays 272. Accordingly, this exemplary embodiment provides an example of a 16 x 16 MIMO antenna array 278, which may comprise a panel type arrangement. The number of ports may be determined by the subarray construction (*e*.*g*., 2x1, 3x1, 4x1, *etc*.), and accordingly, other exemplary embodiments may include more or less than sixteen ports.

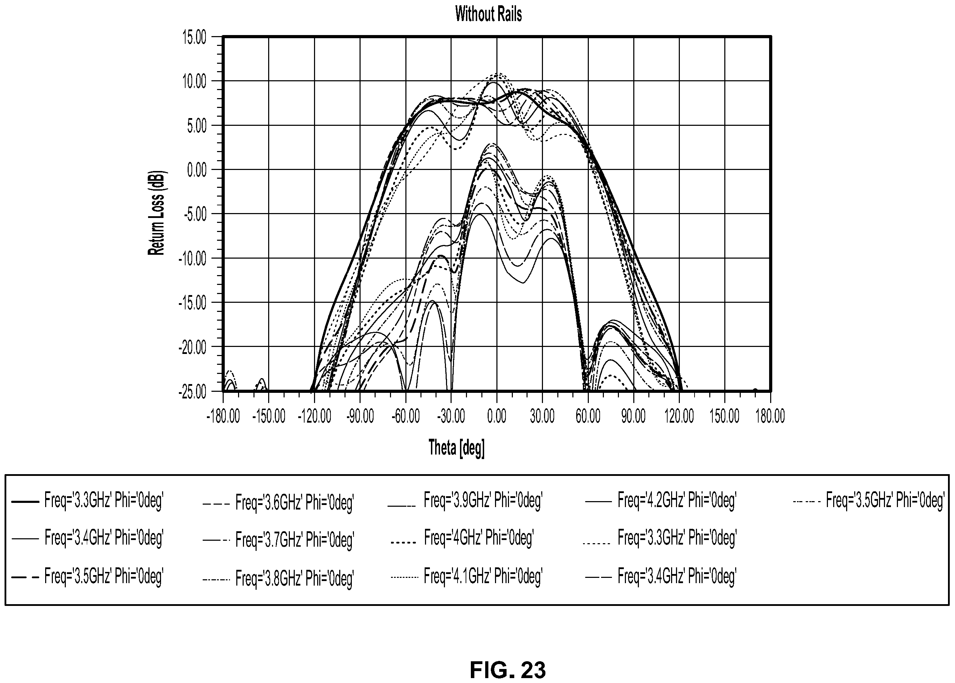

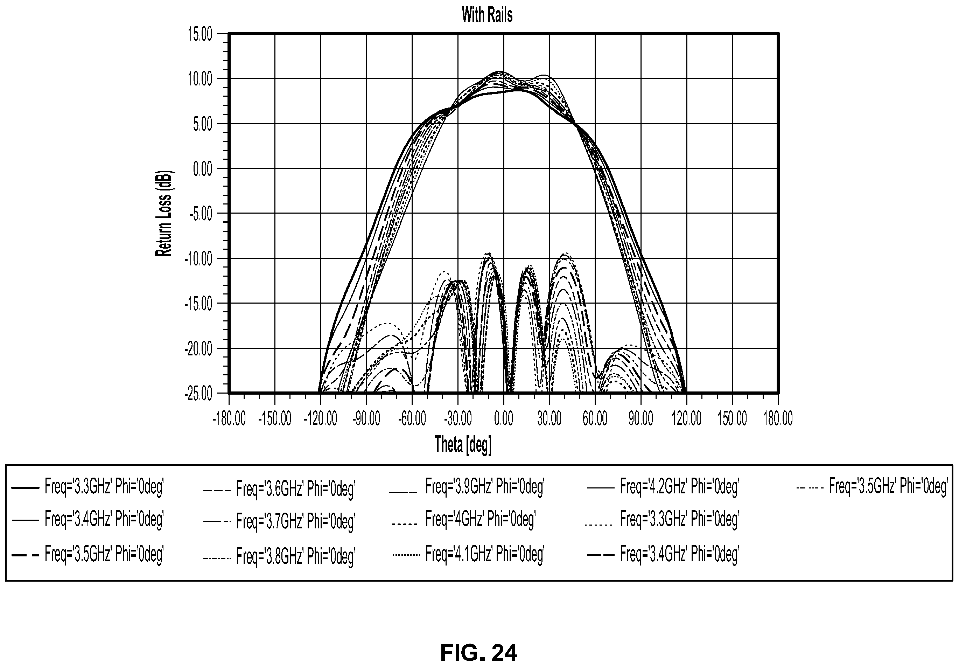

FIGS. 23 and 24 provide analysis results for the MIMO antenna assembly 278 shown in FIGS. 21 and 22. These analysis results are provided only for purposes of illustration and not for purposes of limitation.

More specifically, FIGS. 23 and 24 are exemplary line graphs of return loss in decibels versus Theta from -180 degrees to 180 degrees for the antenna array or MIMO antenna assembly 278 shown in FIG. 21 without isolation rails (FIG. 23) and with isolation rails (FIG. 24) at Phi = 0 degrees at frequencies of 3.3 GHz, 3.4 GHz, 3.5 GHz, 3.6 GHz, 3.7 GHz, 3.8 GHz, 3.9 GHz, 4 GHz, 4.1 GHz, and 4.2 GHz. Generally, FIGS. 23 and 24 show that the antenna array or MIMO antenna assembly 278 had good radiation pattern performance across a frequency range from 3.3 GHz to 4.2 GHz, which was improved by the isolation rails 274.

Accordingly, exemplary embodiments of the stacked patch antenna elements, antenna arrays, and MIMO antenna assemblies disclosed herein may provide one or more (but not necessarily any or all) of the following advantages or features, such as having wideband operation and/or being operable across first and second (or low and high) wide frequency bands. For example, exemplary embodiments disclosed herein may be configured to be operable across at least a frequency band from 3.4 GHz to 3.8 GHz having a bandwidth of about eleven percent. Other exemplary embodiments disclosed herein (*e*.*g*., stacked patch antenna element 200 shown in FIG. 16, MIMO antenna array or assembly 278 shown in FIG. 21, *etc*.) may be configured to be operable across at least a first frequency band from 1.7 GHz to 2.2 GHz having a bandwidth of about twenty-six percent, and a second frequency band from 3.3 GHz to 4.2 GHz having a bandwidth of about twenty-four percent. Exemplary embodiments disclosed herein may be configured to have wider bandwidth performance, straight patterns across the band, low cross-pol across the band, and/or good isolation across the band.

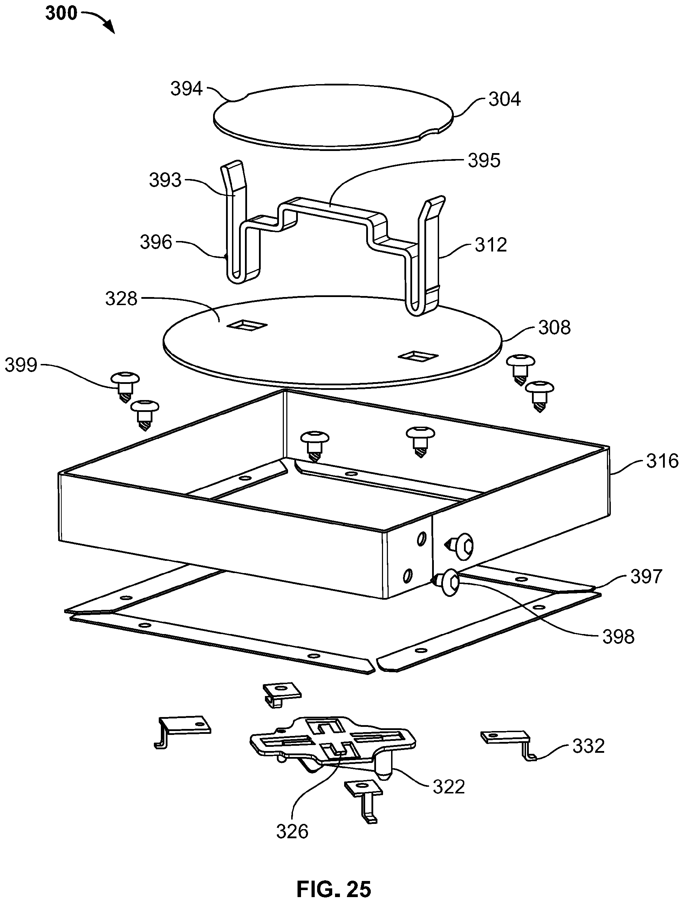

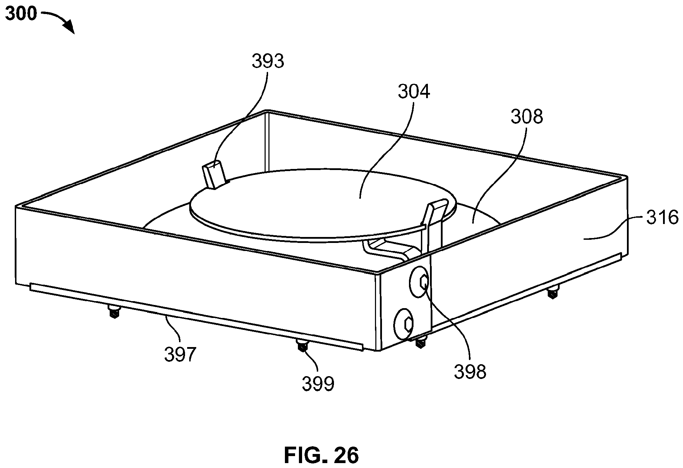

FIGS. 25 and 26 illustrate an example embodiment of a stacked patch antenna panel antenna 300 embodying one or more aspects of the present disclosure. As shown, the stacked patch antenna element 300 includes a top or upper patch 304, a bottom or lower patch 308, a dielectric patch carrier 312, an isolation box or fence 316, and a dielectric feed probe carrier 322.

The dielectric feed probe carrier 322 includes attachment features 326 (*e*.*g*., snap features, *etc*.) for attachment of the feed probes 332. When attached, the feed probes 332 may be supported and carried by the dielectric feed probe carrier 322 for SMT (surface-mount technology) processing. For example, the feed probes 332 may be pre-assembled to the dielectric carrier 322 for SMT processing of the SMT tabs of the feed probes 332. The feed probes 332 may be carried via the dielectric carrier 322 and placed on a surface of a PCB for soldering of the feed probes 332 to corresponding electrically-conductive portions (*e*.*g*., pads, traces, feeds, *etc*.) along the surface of the PCB.

The upper and lower patches 304, 308 are configured to be coupled (*e*.*g*., via integrated features, *etc*.) to the dielectric patch carrier 312. The dielectric patch carrier 312 includes upwardly extending arms 393 (broadly, supports or members) configured to be engagingly positioned within (*e.g.,* snapped into, *etc*.) openings 394 (*e*.*g*., notches, stamped portions, *etc*.) along opposite side edge portions of the upper patch 304 as shown in FIG. 26. The dielectric patch carrier 312 also includes a middle portion 395 configured to be positioned under a middle portion of the upper patch 304, to thereby provide additional support for the upper patch 304.

The arms 393 may be generally resilient such that the arms 393 may be flexed, moved, *etc.* outwardly away from each other when the upper patch 304 is moved along the end portions (*e*.*g*., camming surfaces, *etc*.) of the arms 393. The resiliency urges the arms 393 to their original or initial positioning such that the resilient nature of the arms 393 may cause the arms 393 to move (*e*.*g*., snap back, recoil or spring back into shape after bending, *etc*.) generally over and into engagement with the corresponding openings 394 of the upper patch 304. At which point, the arms 393 are engaged with the upper patch 304, thereby retaining the relative positioning of the upper patch 304 with the dielectric patch carrier 312.

In some exemplary embodiments, a tactile and/or audible indication (*e*.*g*., a click, *etc*.) may be produced when the arms 393 move over and into engagement with the upper patch 304. Advantageously, the upper patch 304 may be held or retained in place on the dielectric patch carrier 312 solely by the arms 393, e.g., without requiring any mechanical fasteners or adhesive between the dielectric patch carrier 312 and the upper patch 304, *etc.*

The dielectric patch carrier 312 also includes lower portions 396 (*e*.*g*., bent elbow portions, *etc*.) configured to be engagingly received within thru holes 328 (broadly, openings) in the lower patch 308. A dielectric or electrically-insulating isolation adhesive 397 may be disposed along a bottom or lower portion of the isolation fence 316. The isolation adhesive 397 may be positioned between the isolation fence 316 and PCB, such that the isolation adhesive 397 inhibits direct galvanic electrical contact between the isolation fence 316 and electrically-conductive portions (*e*.*g*., traces, solder pads, *etc*.) of a PCB. Accordingly, isolation adhesive 397 may thus electrically insulate or isolate the isolation fence 316 from the PCB's electrically-conductive portions.

Mechanical fasteners 398 and 399 are also shown in FIGS. 25 and 26. The mechanical fasteners 398 may be used for mechanically fastening end portions of the isolation fence 316. The mechanical fasteners 399 may be used for mechanical fastening a bottom portion (*e*.*g*., inwardly extending flange, *etc*.) of the isolation fence 316 to the isolation adhesive 397. The isolation fence 316 may be configured to generally surround or be disposed generally about the upper and lower patches 304, 308 as shown in FIG. 26.

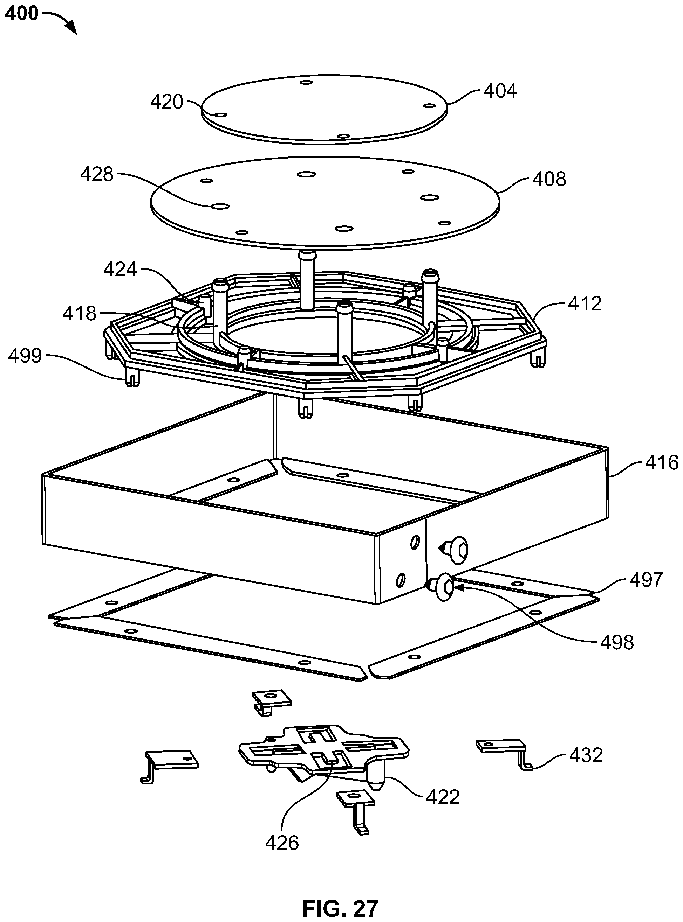

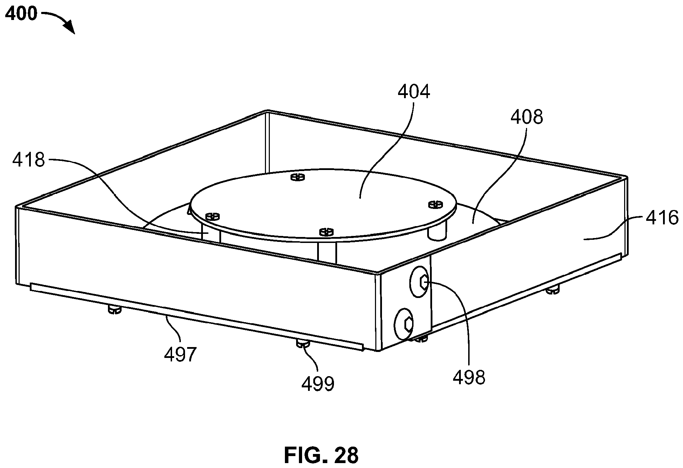

FIGS. 27 and 28 illustrate an example embodiment of a stacked patch antenna panel antenna 400 embodying one or more aspects of the present disclosure. As shown, the stacked patch antenna element 400 includes a top or upper patch 404, a bottom or lower patch 408, a dielectric patch carrier 412, an isolation box or fence 416, and a dielectric feed probe carrier 422.

The dielectric feed probe carrier 422 includes attachment (*e*.*g*., snap, *etc*.) features 426 for attachment of the feed probes 432. When attached, the feed probes 432 may be supported and carried by the dielectric feed probe carrier 422 for SMT (surface-mount technology) processing. For example, the feed probes 432 may be pre-assembled to the dielectric carrier 422 for SMT processing of the SMT tabs of the feed probes 432. The feed probes 432 may be carried via the dielectric carrier 422 and placed on a surface of a PCB for soldering of the feed probes 432 to corresponding electrically-conductive portions (*e*.*g*., pads, traces, feeds, *etc*.) along the surface of the PCB.

The upper and lower patches 404, 408 are configured to be coupled (*e*.*g*., via integrated features, *etc*.) to the dielectric patch carrier 412. The dielectric patch carrier 412 includes upper posts or stakes 418 (broadly, supports or members) configured to be received (*e*.*g*., snapped into, press fit, interference fit, *etc*.) within corresponding aligned thru holes 420, 428 (broadly, openings) in the upper and lower patches 404, 408, respectively. The dielectric carrier 412 also includes shorter posts or stakes 424 (broadly, supports or members) configured to be received within thru holes 428 in the lower patch 408.

The posts 418, 424 may include retention members for assembling and retaining the upper and lower patches 404, 408 to the dielectric patch carrier 412, *e*.*g*., without using mechanical fasteners or adhesive, *etc.* Each retention member may comprise spaced apart locking snaps or latching surfaces along fingers of the post 418, 424, which fingers are separated by a slot. The slot allows the fingers to be moved inwardly toward each other when the upper and/or lower patch 404, 408 is moved, pressed, pushed, *etc.* relatively downward onto the dielectric patch carrier 312. Top portions of the retention members may operate as camming surfaces to urge the fingers of the retention members inwardly toward each other thereby reducing their perimeter size and allowing for insertion through the holes 420, 428 in the upper and lower patches 404, 408, respectively. The fingers of the retention members may be generally resilient, which resiliency urges the fingers to their original or initial positioning such that after the free ends of the fingers have moved past the patch, the resilient nature of the fingers may cause the fingers to move (*e*.*g*., snap back, recoil or spring back into shape after bending, *etc*.) generally over and into engagement with corresponding portions of the patch. At which point, the retention members are engaged with the patch, thereby retaining the relative positioning of the patch with the dielectric patch carrier 412. In some exemplary embodiments, a tactile and/or audible indication (*e*.*g*., a click, *etc*.) may be produced when the retention members move over and into engagement with the corresponding upper or lower patch 404, 408. Advantageously, the upper and lower patches 404, 408 may be held or retained in place on the dielectric patch carrier 412 solely by the retention members of the posts 418, 424, respectively, e.g., without requiring any mechanical fasteners or adhesive between the dielectric carrier 412 and the upper and lower patches 404, 408, *etc.*

In this exemplary embodiment, the upper patch 404 includes four holes 420 spaced apart (*e*.*g*., radially, circumferentially, *etc*.) from each other. The dielectric patch carrier 412 includes four upwardly extending posts 418 along the upper side of the dielectric carrier 412. The lower patch 408 includes four holes 428 aligned with the holes 420 in the upper patch 404. The lower patch 408 also includes four additional holes 428 that engagingly receive the shorter posts 424 and that are spaced apart (*e*.*g*., radially, circumferentially, *etc*.) from each other. Alternative embodiments may be configured differently, *e*.*g*., with more or less holes and posts and/or at other locations, *etc.*

A dielectric or electrically-insulating isolation adhesive 497 may be disposed along a bottom or lower portion of the isolation fence 416. The isolation adhesive 497 may be positioned between the isolation fence 416 and PCB, such that the isolation adhesive 497 inhibits direct galvanic electrical contact between the isolation fence 416 and electrically-conductive portions (*e*.*g*., traces, solder pads, *etc*.) of a PCB. Accordingly, the isolation adhesive 497 may thus electrically insulate or isolate the isolation fence 416 from the PCB's electrically-conductive portions.

Mechanical fasteners 498 may be used for mechanically fastening end portions of the isolation fence 416. The dielectric patch carrier 412 may include downwardly protruding posts or stakes 499 (broadly, portions) for coupling the isolation adhesive 497 to the isolation fence 416. The posts 499 of the dielectric patch carrier 412 may be configured to be engagingly received within corresponding aligned openings along a bottom portion (*e*.*g*., inwardly extending flange, *etc*.) of the isolation fence 416 and the isolation adhesive 497. The isolation fence 416 may be configured to generally surround or be disposed generally about the upper and lower patches 404, 408 as shown in FIG. 28.

The posts 499 may include retention members for assembling and retaining the isolation adhesive 497 to the isolation fence 416, e.g., without using mechanical fasteners or adhesive, *etc.* Each retention member may comprise spaced apart locking snaps or latching surfaces along fingers of the post 499, which fingers are separated by a slot. The slot allows the fingers to be moved inwardly toward each other when the post 499 is moved, pressed, pushed, *etc.* relatively downward through the openings in the isolation adhesive 497 and bottom portion of the isolation fence 416. Bottom portions of the retention members may operate as camming surfaces to urge the fingers of the retention members inwardly toward each other thereby reducing their perimeter size and allowing for insertion through the holes in the isolation fence 416 and the isolation adhesive 497. The fingers of the retention members may be generally resilient, which resiliency urges the fingers to their original or initial positioning such that after the free ends of the fingers have moved past the isolation adhesive 497, the resilient nature of the fingers may cause the fingers to move (*e*.*g*., snap back, recoil or spring back into shape after bending, *etc*.) generally over and into engagement with corresponding portions of the isolation adhesive 497. At which point, the retention members are engaged with the isolation adhesive 497, thereby retaining the relative positioning of the isolation adhesive 497 with the isolation fence 416. In some exemplary embodiments, a tactile and/or audible indication (*e*.*g*., a click, *etc*.) may be produced when the retention members move over and into engagement with the isolation adhesive 497.

The configuration of the stacked patch antenna element 300 (FIGS. 25 and 26) and/or 400 (FIGS. 27 and 28) may provide one or more (but not necessarily any or all) of the following advantages or features, such as being operable with low passive intermodulation (PIM) performance, low cost, configured to allow for SMT of feed probes separately, and/or repeatability of assembly process. For example, the stacked patch antenna element 300 (FIGS. 25 and 26) and/or 400 (FIGS. 27 and 28) may be configured to allow for low PIM performance, pre-assembly of the feed probes for SMT processing, use snap features to reduce (e*.g*., eliminate, *etc*.) the need of additional mechanical fasteners, and allows for SMT processing to provide reduced assembly time and increase repeatability. In exemplary embodiments, the stacked patch antenna element 300 and/or 400 may be arrayed along a PCB for a Multi-MIMO scanning array. In other exemplary embodiments, the stacked patch antenna element 300 and/or 400 may be used in a single element application.

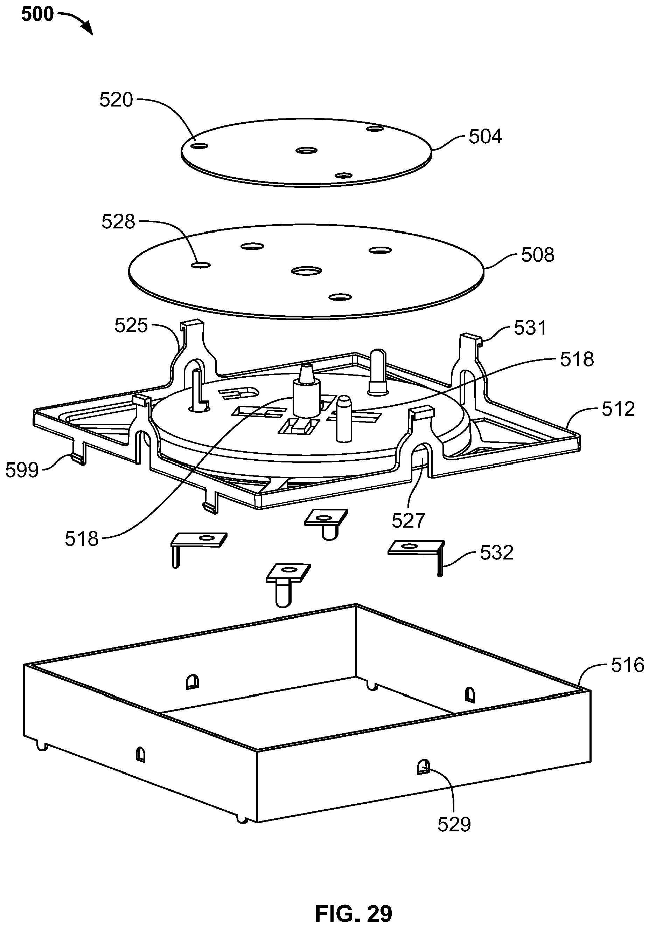

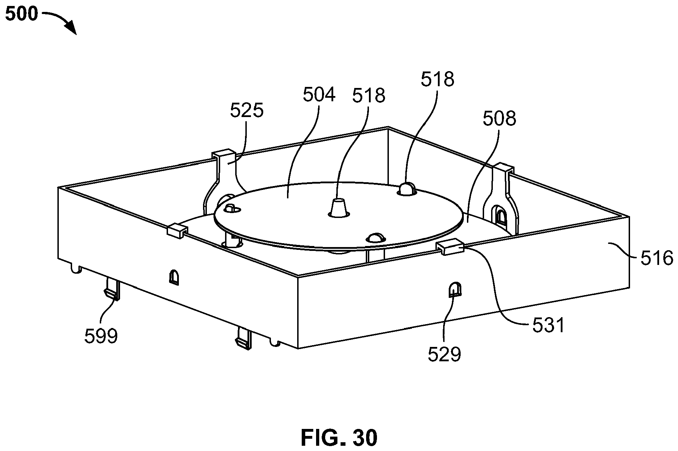

FIGS. 29 and 30 illustrate an example embodiment of a stacked patch antenna panel antenna 500 embodying one or more aspects of the present disclosure. As shown, the stacked patch antenna element 500 includes a top or upper patch 504, a bottom or lower patch 508, a dielectric carrier 512, and an isolation box or fence 516.

The dielectric carrier 512 includes attachment features (*e*.*g*., snap features, *etc.)* for attachment of the feed probes 532, the upper patch 504, and the lower patch 508. The feed probes 532 may be attached to and carried by the dielectric carrier 512. For example, the feed probes 532 may be carried via the dielectric carrier 512 and placed on a surface of a PCB for soldering (*e*.*g*., wave soldering, *etc*.) of the tabs of the feed probes 532 to corresponding electrically-conductive portions (*e*.*g*., pads, traces, feeds, *etc*.) along the surface of the PCB.

The isolation fence 516 may be configured to generally surround or be disposed generally about the upper and lower patches 504, 508 as shown in FIG. 30. The isolation fence 516 may include wave solder tabs along the lower portion of the isolation fence 516.

The upper and lower patches 504, 508 are configured to be coupled (*e*.*g*., via integrated features, *etc*.) to the dielectric carrier 512. The dielectric carrier 512 includes upper posts or stakes 518 (broadly, supports or members) configured to be received (*e*.*g*., snapped into, press fit, interference fit, *etc*.) within corresponding aligned thru holes 520, 528 (broadly, openings) in the upper and lower patches 504, 508, respectively. The dielectric carrier's posts 518 and the holes 520, 528 in the in the upper and lower patches 504, 508, respectively, may be configured for assembling and retaining the upper and lower patches 504, 508 to the dielectric carrier 512, *e*.*g*., without using mechanical fasteners or adhesives, *etc.*

The dielectric carrier 512 also includes outer posts or stakes 525 (broadly, supports or members) configured to be positioned along inner surfaces of the isolation fence 516. The outer posts 525 include protruding portions 527 configured to be engagingly received within corresponding openings 529 in the walls of the isolation fence 516. The outer portions 525 also include upper portions 531 (*e*.*g*., hooks, u-shaped end portions, *etc*.) configured to be engaged with (*e*.*g*., hooked onto, *etc*.) the upper edges of the isolation fence 516 as shown in FIG. 30. The dielectric carrier's posts 525 and the isolation fence 516 may be configured for assembling and retaining the dielectric carrier 512 to the isolation fence, *e.g.,* without using mechanical fasteners or adhesive, *etc.*

The dielectric carrier 512 further includes downwardly protruding tabs 599 (broadly, portions). The tabs 599 may be configured (*e*.*g*., with snap features, *etc*.) to be engagingly received within openings in the PCB to help secure or retain the positioning of the stacked patch antenna element 500 in place on the PCB during soldering.

In this exemplary embodiment, the upper patch 504 includes four holes 520 spaced apart (*e*.*g*., three holes radially or circumferentially spaced apart and a center hole, *etc*.) from each other. The dielectric carrier 512 includes four upwardly extending posts 518. The lower patch 508 includes four holes 528 aligned with the holes 520 in the upper patch 504. Alternative embodiments may be configured differently, e.g., with more or less holes and posts and/or at other locations, *etc.*

The configuration of the stacked patch antenna element 500 (FIGS. 29 and 30) may provide one or more (but not necessarily any or all) of the following advantages or features, such as being operable with low passive intermodulation (PIM) performance, low cost, reduced assembly time, and/or repeatability of assembly process. For example, the stacked patch antenna element 500 may be configured to allow for low PIM performance, pre-assembly of the antenna element, use snap features to reduce (*e*.*g*., eliminate, *etc*.) the need of additional mechanical fasteners, and allows for wave soldering to provide reduced assembly time and increase repeatability. In exemplary embodiments, the stacked patch antenna element 500 may be arrayed along a PCB for a Multi-MIMO scanning array. In other exemplary embodiments, the stacked patch antenna element 500 may be used in a single element application.

Upper and lower patches in exemplary embodiments may be made of solderable material (*e*.*g*., tin plated steel, brass, beryllium copper, *etc*.) that is stamped to provide the overall shape and thru holes. Alternatively, other electrically-conductive materials and/or other manufacturing processes besides stamping may be used for either or both the upper and lower patches.

An isolation rail in exemplary embodiments may include a generally horizontal upper portion between two downwardly extending leg portions. The leg portions may be generally perpendicular to the upper connecting portion such that the isolation rail has a generally inverted U shaped profile or a C shaped profile. Accordingly, the isolation rail may comprise a C channel member or structure. The isolation rail may be made of aluminum that is stamped and formed (*e*.*g*., bent, folded, deformed, *etc*.). Alternatively, other electrically-conductive materials besides aluminum and/or other manufacturing processes besides stamping and forming may be used for an isolation rail.

Exemplary embodiments may include a multilayer PCB comprising a 4-layer radio frequency (RF) PCB including top and bottom layers (*e*.*g*., ground plane layers, *etc*.) and two inner layers (*e*.*g*., signal layers, *etc*.) disposed generally between the top and bottom layers. Either or both of the inner layers may include electrically-conductive traces (*e*.*g*., copper traces, *etc*.) defining a feed network (*e*.*g*., a strip feedline network, *etc*.) and a calibration network. The PCB may be made from various materials, such as PTFE based PCB materials, ceramic loaded substrates, FR4, *etc.* The PCB may also include more or less than four layers in other exemplary embodiments. In exemplary embodiments, the multilayer PCB may include coupling traces, power dividers, and feeding networks. The multilayer PCB may include pads for soldering resistors, shielding boxes, element feeds, connectors, *etc.* The PCB may further include mounting holes and other mechanical attachment points for attachment to an antenna filter or radio module, which may be assembled onto the PCB.

Exemplary embodiments may include stacked patch antennas disclosed herein in various antenna array sizes, groupings, or orientations, such as two-by-two arrays, three-by-three arrays, two-by-eight arrays, four-by-three arrays, rectangular arrays, non-rectangular arrays, triangular arrays, linear arrays, circular arrays, other groupings or arrangements of antenna elements that are not in an array, *etc.*

In exemplary embodiments that include a plurality of (*e*.*g*., an array, *etc*.) of stacked patch antenna elements, isolation boxes may be placed along and/or electrically coupled with a relatively large ground plane common to all the SMT stacked patch antenna elements. The isolation boxes may have a generally rectangular or non-rectangular shape (*e*.*g*., triangular or hexagonal when viewed from above, *etc*.) depending on the particular configuration of the antenna assembly or system (*e*.*g*., antenna array or panel assembly, *etc*.) in which it will be used.

The walls of an isolation box may be different on different sides. For example, the walls of an isolation box may vary in height and/or shape. In addition, one or more horizontal, vertical, diagonal, *etc.* slots may be provided in one or more walls of an isolation box to change the mutual coupling between the patches or radiating elements. One or more walls of an isolation box may be configured to slanted and non-perpendicular to a ground plane. An isolation box may be made of solderable material (*e*.*g*., tin plated steel, brass, beryllium copper, *etc*.) that is stamped to provide the overall shape, openings, other features, *etc.* Portions of the stamped material may then be formed (*e*.*g*., bent, folded, deformed, *etc*.) to provide the sidewalls and other possible features (*e*.*g*., SMT tabs, latching members, *etc*.). Alternatively, other electrically-conductive materials and/or other manufacturing processes besides stamping and forming may also be used for an isolation box.

Example embodiments are provided so that this disclosure will be thorough, and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i*.*e*., the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3-10, and 3-9.

The terminology used herein is for the purpose of describing particular example embodiments only and is not intended to be limiting. As used herein, the singular forms "a," "an," and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on," "engaged to," "connected to," or "coupled to" another element or layer, it may be directly on, engaged, connected or coupled to the other element or layer, or intervening elements or layers may be present. In contrast, when an element is referred to as being "directly on," "directly engaged to," "directly connected to," or "directly coupled to" another element or layer, there may be no intervening elements or layers present. Other words used to describe the relationship between elements should be interpreted in a like fashion (*e*.*g*., "between" versus "directly between," "adjacent" versus "directly adjacent," *etc*.). As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally," "about," and "substantially," may be used herein to mean within manufacturing tolerances.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath," "below," "lower," "above," "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A stacked patch antenna element comprising:
an upper patch;
a lower patch;
a dielectric patch carrier configured to support at least one of the upper and lower patches without requiring mechanical fasteners for mechanically attaching the at least one of the upper and lower patches to the dielectric patch carrier; and
one or more electrically-conductive walls disposed generally around the upper and lower patches.

2. The stacked patch antenna element of claim 1, wherein:
the one or more electrically-conductive walls include an electrically-conductive bottom wall and electrically-conductive sidewalls defining an isolation box in which are disposed the upper and lower patches;
the lower patch includes one or more SMT (surface-mount technology) tabs extending through a corresponding one or more openings in the electrically-conductive bottom wall, the one or more SMT tabs of the lower patch configured for placement on and soldering to a corresponding one or more electrically-conductive portions along a printed circuit board, whereby the one or more SMT tabs of the lower patch are operable as one or more feed probes; and
the isolation box includes one or more SMT tabs configured for placement on and soldering to a corresponding one or more portions along the printed circuit board for grounding and/or mechanical attachment of the isolation box and the printed circuit board.

3. The stacked patch antenna element of claim 1, wherein:
the lower patch includes one or more tabs that are configured to be insertable into a corresponding one or more thru-holes in a printed circuit board from a first side of the printed circuit board and solderable to a corresponding one or more electrically-conductive portions along a second side of the printed circuit board opposite the first side; and
the one or more electrically-conductive walls include one or more tabs that are configured to be insertable into a corresponding one or more thru-holes in the printed circuit board from the first side of the printed circuit board and solderable to a corresponding one or more portions along the second side of the printed circuit board opposite the first side for grounding and/or mechanical attachment of the one or more electrically-conductive walls and the printed circuit board.

4. The stacked patch antenna element of claim 1, wherein:
the one or more electrically-conductive walls include one or more wave solder tabs configured for placement on and soldering to a corresponding one or more portions along a printed circuit board for grounding and/or mechanical attachment of the one or more electrically-conductive walls and the printed circuit board; and
the stacked patch antenna element comprises one or more feed probes including one or more wave solder tabs.

5. The stacked patch antenna element of claim 1, wherein:
the stacked patch antenna element comprises symmetrical capacitive probes for capacitively feeding the upper and lower patches; and
the lower patch includes a plurality of openings, each said opening generally between a corresponding one of the symmetrical capacitive probes and a center of the stacked patch antenna element.

6. The stacked patch antenna element of claim 1, wherein:
the stacked patch antenna element comprises one or more feed probes including one or more SMT (surface-mount technology) tabs; and
the stacked patch antenna element further includes a dielectric feed probe carrier configured to be coupled to and/or to support the one or more feed probes for SMT processing, whereby the dielectric feed probe carrier is usable for carrying and placing the one or more feed probes along a surface of a printed circuit board for soldering of the one or more SMT tabs of the one or more feed probes to a corresponding one or more electrically-conductive portions along the surface of the printed circuit board; and/or

7. The stacked patch antenna element of any one of the preceding claims, wherein the dielectric patch carrier comprises one or more tabs extending downwardly from the dielectric patch carrier and configured to be engagingly received within corresponding openings in a printed circuit board, whereby engagement of the one or more tabs within the corresponding openings in the printed circuit board retains positioning of the stacked patch antenna element relative to the printed circuit board.

8. The stacked patch antenna element of any one of the preceding claims, wherein:
the dielectric patch carrier includes upper and lower posts extending upwardly and downwardly, respectively, from the dielectric patch carrier;
the upper posts are configured to be received within openings in the upper patch to thereby mechanically couple and align the upper patch with the dielectric patch carrier;
the lower posts are configured to be received within openings in the lower patch to thereby mechanically couple and align the lower patch with the dielectric patch carrier;
the one or more electrically-conductive walls include an electrically-conductive bottom wall and electrically-conductive sidewalls defining an isolation box in which are disposed the upper and lower patches; and
the electrically-conductive bottom wall includes at least two openings configured for respectively receiving at least two of the lower posts to thereby mechanically couple and align the isolation box with the dielectric patch carrier.

9. The stacked patch antenna element of claim 8, wherein the isolation box includes one or more latching members along the electrically-conductive sidewalls configured to be engagingly received and retained within corresponding openings along sidewalls of the dielectric patch carrier, to thereby retain relative positioning of the dielectric patch carrier within the isolation box; and/or
wherein:
at least one of the upper posts include fingers separated by a slot and latching surfaces along the fingers,
the slot is configured to allow the fingers to be moved inwardly toward each other when the upper patch is moved relatively downward onto the upper posts; and
the latching surfaces are configured to engage corresponding portions of the upper patch after the latching surfaces are positioned within a corresponding one of the openings of the upper patch, to thereby retain the upper patch in place on the dielectric patch carrier.

10. The stacked patch antenna element of claim 8 or 9, wherein:
the lower patch includes SMT (surface-mount technology) tabs that are integral portions of the lower patch configured for placement on and soldering to a corresponding one or more electrically-conductive portions along a printed circuit board, whereby the SMT tabs of the lower patch are operable as one or more feed probes;
the isolation box includes SMT tabs that are integral portions of the isolation box configured for placement on and soldering to a corresponding one or more portions along the printed circuit board for grounding and/or mechanical attachment of the isolation box and the printed circuit board; and
the dielectric patch carrier is configured for positioning within the isolation box in a single orientation in which the SMT tabs of the lower patch are aligned with and extend through openings of the isolation box.

11. The stacked patch antenna element of any one of claims 1 to 7, wherein the dielectric patch carrier comprises:
a middle portion configured to be positioned under the upper patch to provide support for the upper patch;
resiliently flexible arms along opposite sides of the middle portion, the arms configured to flex outwardly relative to each other for positioning within openings along opposite side edge portions of the upper patch, whereby engagement of the arms within the openings retains the upper patch on the dielectric patch carrier; and
lower portions generally between the arms and the middle portion, the lower portions configured to be engagingly received within openings in the lower patch.

12. The stacked patch antenna element of any one of claims 1 to 7, wherein the dielectric patch carrier comprises:
one or more first upper posts extending upwardly from the dielectric patch carrier and configured to be engagingly received within corresponding aligned first openings in the lower and upper patches; and
one or more second upper posts extending upwardly from the dielectric patch carrier, the one or more second upper posts shorter than the one or more first posts and configured to be engagingly received within corresponding one or more second openings in the lower patch;
whereby engagement of the first and second upper posts within the corresponding first and second openings, respectively, mechanically couples and aligns the upper and lower patches with the dielectric patch carrier; and
wherein the stacked patch antenna element further comprises a dielectric adhesive configured to be disposed along a bottom portion of the one or more electrically-conductive walls for inhibiting direct galvanic electrical contact between the one or more electrically-conductive walls and one or more electrically-conductive portions of a printed circuit board; and
wherein the dielectric patch carrier further includes one or more lower posts extending downwardly from dielectric patch carrier and configured to be engagingly received within corresponding aligned openings along the bottom portion of the one or more electrically-conductive walls and dielectric adhesive.

13. The stacked patch antenna element of claim 1, wherein the dielectric patch carrier comprises:
one or more upper posts extending upwardly from the dielectric patch carrier and configured to be engagingly received within corresponding aligned first openings in the lower and upper patches, whereby engagement of the one or more upper posts within the aligned openings of the lower and upper patches retains the lower and upper patches on the dielectric patch carrier; and
one or more outer posts extending upwardly from the dielectric patch carrier and configured to be positioned along one or more inner surfaces of the one or more electrically-conductive walls, the one or more outer posts include one or more upper portions configured to be engaged with one or more upper edges of the one or more electrically-conductive walls, whereby engagement of the one or more outer posts with the one or more electrically-conductive walls retains the dielectric patch carrier to the one or more electrically-conductive walls.

14. A multiple input multiple output (MIMO) antenna assembly comprising:
one or more rows of one or more subarrays, each said subarray including at least two stacked patch antenna elements of any one of claims 1 to 12; and
one or more electrically-conductive rails, each said electrically-conductive rail extending along a corresponding one of the one or more rows generally between the two stacked patch antenna elements in each subarray;
whereby the one or more electrically-conductive walls and the one or more electrically-conductive rails are configured to be operable for providing isolation between the stacked patch antenna elements.

15. The MIMO antenna assembly of claim 14, further comprising a multilayer printed circuit board including upper and lower ground plane layer and one or more inner layers generally between the upper and lower ground plane layers, the one or more inner layers including electrically-conductive traces defining a feed network and a calibration network, wherein the stacked patch antenna elements are positioned along and electrically coupled with the upper ground plane layer of the multilayer printed circuit board; and wherein:
the one or more rows comprise:
at least a first row including at least four of the subarrays; and
a second row including at least four of the subarrays;
the one or more electrically-conductive rails comprise at least:
a first isolation rail along the first row between the stacked patch antenna elements of each subarray of the first row; and
a second isolation rail along the second row between the stacked patch antenna elements of each subarray of the second row;
whereby the antenna assembly includes at least eight subarrays and at least sixteen of the stacked patch antenna elements.
